# EUROPEAN PATENT APPLICATION

(11) **EP 4 592 884 A1**
(43) Date of publication of application: **30.07.2025**
(21) Application number: 25154766.7
(22) Date of filing: 29.01.2025
(51) Int. Cl.: G06F 30/10, G06T 19/00, G06F 3/04842, G06T 17/10, G06T 19/20

(54) **GENERATING A CROPPED REPRESENTATION OF A COMPUTER-AIDED DESIGN THREE DIMENSIONAL MODEL**

(30) Priority: 29.01.2024 US 202418425646
(71) Applicant: Dassault Systemes SolidWorks Corporation, Waltham, MA 02451-1223 (US)
(72) Inventor: Lorono, Matthew, Waltham, 02451 (US)
(74) Representative: Bandpay & Greuter

(57) **Abstract**

A method of creating a cropped representation of a computer-generated, three-dimensional (3D) computer aided design (CAD) model includes: displaying the model on a computer display, receiving an indication that an element from the displayed model has been selected as target geometry, creating a boundary shape on the selected target geometry, extending a perimeter of the boundary shape in a normal direction through the model to establish a boundary, partitioning the model at the boundary to demarcate a first portion of the model inside the boundary from a second portion of the model outside the boundary, and generating a visual depiction of the cropped representation of the model based on the partitioned model by visually displaying the first portion of the model inside the boundary and by hiding or displaying as transparent with edges only the second portion of the model outside the boundary.

## Description

### FIELD OF THE INVENTION

This disclosure relates to the field of design and, more particularly, relates to computer-based systems and methods for generating a cropped representation of a computer-aided design (CAD) three-dimensional (3D) model.

### BACKGROUND

Computer-aided design (CAD) software enables a user to construct, view, and manipulate three-dimensional (3D) models.

The models can be created using a number of different modeling techniques including, for example, solid modeling, wire-frame modeling, and surface modeling. CAD software may combine these and/or other modeling techniques, such as parametric modeling techniques.

CAD systems may support two-dimensional (2D) representations of 3D objects. 2D and 3D representations can be useful to consider during different stages of a design process.

A design engineer is a typical user of a 3D CAD system. The design engineer designs physical and aesthetic aspects represented in a 3D model and is generally skilled in 3D modeling techniques.

Cropping refers to a process whereby a first portion of an individual component or product assembly in an image is removed or hidden from view while a second portion of the individual component or product assembly remains intact and visible within the image. Cropped representations of an object can be useful in showing the design engineer or a manufacturer details of a component or product that might otherwise be difficult to discern.

### SUMMARY OF THE INVENTION

In one aspect, a computer-based method is disclosed for creating a cropped representation of a computer-generated, three-dimensional (3D) computer aided design (CAD) model. The method includes: displaying the model on a computer display, receiving an indication that an element from the displayed model has been selected as target geometry, creating a boundary shape on the selected target geometry, extending a perimeter of the boundary shape in a normal direction through the model to establish a boundary, partitioning the model at the boundary to demarcate a first portion of the model inside the boundary from a second portion of the model outside the boundary, and generating a visual depiction of the cropped representation of the model based on the partitioned model by visually displaying the first portion of the model inside the boundary and by hiding or displaying as transparent with edges only the second portion of the model outside the boundary. In a typical implementation, the method includes displaying the boundary as a solid surface in the visual depiction of the cropped representation of the computer-generated 3D CAD model.

In another aspect, a computer-based system is disclosed for generating a cropped representation of a computer-aided design three-dimensional (3D) model. The computer-based system includes one or more computer processing devices; and computer-based memory operatively coupled to the one or more processing devices. The computer-based memory stores computer-readable instructions that, when executed by the one or more processors, cause the computer-based system to perform a method that includes: displaying the model on a computer display, receiving an indication that an element from the displayed model has been selected as target geometry, creating a boundary shape on the selected target geometry, extending a perimeter of the boundary shape in a normal direction through the model to establish a boundary, partitioning the model at the boundary to demarcate a first portion of the model inside the boundary from a second portion of the model outside the boundary, and generating a visual depiction of the cropped representation of the model based on the partitioned model by visually displaying the first portion of the model inside the boundary and by hiding or displaying as transparent with edges only the second portion of the model outside the boundary. In a typical implementation, the method includes displaying the boundary as a solid surface in the visual depiction of the cropped representation of the computer-generated 3D CAD model.

In yet another aspect, a non-transitory computer readable medium is disclosed having stored thereon computer-readable instructions that, when executed by a computer-based processor, cause the computer-based processor to generate a cropped representation of a computer-aided design three-dimensional (3D) model in accordance with a method that includes: displaying the model on a computer display, receiving an indication that an element from the displayed model has been selected as target geometry, creating a boundary shape on the selected target geometry, extending a perimeter of the boundary shape in a normal direction through the model to establish a boundary, partitioning the model at the boundary to demarcate a first portion of the model inside the boundary from a second portion of the model outside the boundary, and generating a visual depiction of the cropped representation of the model based on the partitioned model by visually displaying the first portion of the model inside the boundary and by hiding or displaying as transparent with edges only the second portion of the model outside the boundary. In a typical implementation, the method includes displaying the boundary as a solid surface in the visual depiction of the cropped representation of the computer-generated 3D CAD model.

In some implementations, one or more of the following advantages are present.

For example, within a computer-implemented 3D model-based definition (MBD) environment, the systems and techniques disclosed herein bring attention to specific geometry of a computer-generated 3D model of a product (object) to the exclusion of other geometry of the computer-generated 3D model of the product. This helps bring focus to the product definition of the specific geometry in a similar manner as provided traditionally with hand drawn 2D drawings in the form of detail views and crop views, for example. In various implementations, the systems and techniques disclosed herein are typically able to quickly generate 3D model presentations for isolation of geometry provided by detail and crop views per international standards within a computer-implemented MBD environment, for example. In various implementations, the systems and techniques disclosed herein apply such presentations of a model within a 2D drawing thereof in a way that allows for interaction with the isolated geometry to measure and annotate data referencing the full geometry of a product while in the presentation of isolated geometry.

Additionally, in various implementations, the systems and techniques disclosed herein provide control to generate and modify the geometry of isolation boundaries, which determine isolated geometry (geometry included within a presentation) and excluded geometry (geometry that is removed from the presentation). By further extension, implementations of the systems and techniques disclosed herein show isolated geometry as a separate presentation within a 3D model in a manner that does not interfere with or modify the geometry of the 3D model. A partitioned or cropped view state showing isolated geometry from a computer-generated 3D model, may be shown in a separate view from the unpartitioned or uncropped view thereof. Typically, if a change is made to a computer-generated 3D model in the partitioned or cropped view state, then the corresponding computer-generated 3D model in the unpartitioned or uncropped view state is updated to reflect the change, and if a change is made to the computer-generated 3D model in the unpartitioned or uncropped view state, then the computer-generated 3D model in the partitioned or cropped view state is updated to reflect the modification.

Implementations of the systems and techniques disclosed herein, within a computer-implemented 3D modelling assembly environment, allow for isolation of a geometry from multiple bodies and components of an assembly of 3D models. Moreover, implementations of systems and techniques disclosed herein enable a user to specify scale of the isolated geometry presentation in a partitioned or cropped view of a computer-generated 3D model and for that scale to be different (e.g., larger) than the scale of the corresponding unpartitioned or uncropped view of the computer-generated 3D model. This improves efficiency of viewing both the partitioned or cropped view of the computer-generated 3D model and the unpartitioned or cropped view of the computer-generated 3D model.

Additionally, implementations of the systems and techniques disclosed herein generate section views (e.g., a partitioned or cropped view) without a feature to cut the model. Moreover, the resulting partitioned or cropped views may be stored within the model.

The ability of a design engineer to easily view both a computer-generated 3D model and a partitioned or cropped view of the computer-generated 3D model may improve efficiency of the design process and has the potential to reduce the number of edits and interactions between the design engineer and the CAD system to produce a finished model of a real world object (or product) to be manufactured. This is because the design engineer will have a better understanding of all aspects of the product including those shown clearly in the partitioned or cropped view but otherwise difficult to discern in the uncropped view.

Once the model is finished, the real world object is subsequently manufactured using one or more real-world machines and/or manufacturing techniques. Implementations of the systems and techniques disclosed herein include using the results of the design/modeling processes for manufacturing the real-world object, and manufacturing the real-world object based on those results. The designing/modeling, therefore, has an impact on the physical real-world object and its manufacturing when the output is used. **In** some implementations, the manufacturer may consult both the original computer-generated 3D model, any 2D drawings derived therefrom, and/or any cropped views of the original computer-generated 3D model, to fully understand the design, set up and/or control manufacturing machinery and processes.

**In** some implementations, data associated with and representing the model (including information in a cropped representation thereof) may be entered into a CNC machine, via the input/output interface on the computer, and that data may be fed into the CNC machine in order to direct the CNC machine to produce a real-world version of the object represented by the virtual computer-generated 3D model. CNC stands for "computer numerical control" and a CNC machine is a programmable machine that can perform various manufacturing operations autonomously (e.g., based on a computer-generated 3D model).

**In** examples, implementations of the systems and techniques disclosed herein may comprise one or more of the following:
- the generating the visual depiction of the cropped representation of the computer-generated 3D CAD model further comprises: displaying the boundary as a solid surface;
- the boundary shape is stored in the computer-based memory as supplemental geometry or as a sketch entity in logical association with the cropped representation of the computer-generated 3D CAD model being created and for which the boundary shape was created;
- the computer further comprises:
   ∘ a graphics renderer,
   ∘ wherein the computer-generated 3D CAD model is provided, in its entirety, to the graphics renderer for generating the visual depiction, wherein generating the visual depiction further comprises, for each pixel of the computer-generated 3D CAD model provided to the graphics renderer:
      ▪ determining whether that pixel is in the first portion of the computer-generated 3D CAD model or in the second portion of the computer-generated 3D CAD model; and
      ▪ deciding whether to render that pixel based on whether that pixel is determined to be in the first portion of the computer-generated 3D CAD model or in the second portion of the computer-generated 3D CAD model;
- the cropped representation of the computer-generated 3D CAD model is stored in the computer-based memory as a restorable view state of the computer-generated 3D CAD model;
- a real world machine for manufacturing a real world object that corresponds to the computer-generated 3D CAD model, wherein the computer-generated 3D CAD model and the cropped representation of the computer-generated 3D CAD model are used in connection with manufacturing the real world object with the real world machine; and
- the real world machine is a computer numerical control (CNC) machine connected via an interface to the computer.

Other features and advantages will be apparent from the description and drawings, and from the claims.

### BRIEF DESCRIPTION OF THE DRAWINGS

FIG. 1 is a schematic representation of an exemplary computer configured to generate a cropped representation of a computer-aided design (CAD) three-dimensional (3D) model.
FIGS. 2A-2H is a flowchart representation that identifies computer implemented processes and functionalities for generating a cropped representation of a computer-generated 3D CAD model.
FIGS. 3A-3I include a visual depiction of a computer-generated 3D model or portions thereof (that may be displayed, for example, on a user interface of a CAD program) at various stages of a cropping process.
FIG. 3J represents an example of scaling in the context of a 2D cropped representation of a computer-generated 3D model.

Like reference characters refer to like elements.

### DETAILED DESCRIPTION

This document uses a variety of terminology to describe various concepts. Unless otherwise indicated, the following terminology, and variations thereof, should be understood as having meanings that are consistent with what follows.

For example, the phrase, "computer-aided design" (or CAD), as used herein, refers to the design of individual components and/or product assemblies, for example, aided by the use of a computer. The computer in a CAD environment may aid in the creation, modification, analysis, and/or optimization of an individual component and/or product assembly being designed. The individual component and/or product assemblies may be represented, for example, in one or plans or specifications, including in a three-dimensional models stored in computer-based memory, and may include various manufacturing specifications for the , within the context of model-based definition (MBD), for example. The SOLIDWORKS^{®} computer program, available from Dassault Systèmes SolidWorks Corporation, the applicant of the current application, is one example of a software program that facilitates such computer-aided design. However, the phrase "computer-aided design" (or CAD) should be construed broadly to include any computer software, device, or system that incorporates or can incorporate or facilitate the computer-based functionalities disclosed herein for generating a cropped representation of a computer-aided design (CAD) three-dimensional (3D) model.

The phrase "model editing environment" refers to a computer-implemented environment wherein a visual depiction of a real world object that corresponds to a virtual 3D model, and/or portions thereof, may be created, displayed, and/or edited through a visual interface on a computer display. In a typical implementation, a model editing environment will include, or provide access to, user-selectable tools to facilitate model creation and/or editing.

The phrase "model-based definition" (or "MBD"), sometimes referred to as digital product definition (or DPD), is the practice of utilizing 3D models within a 3D CAD software environment to define (provide specifications for) individual components and/or product assemblies. The 3D models may include, for example, solid models, either alone or in combination with 3D product and manufacturing information ("PMI"), and/or associated metadata. The types of information included in MBDs may include, for example, geometric dimensioning and tolerancing (GD&T) information, component level material information, assembly level bills of materials, engineering configuration information, design intent information, etc. MBD can be contrasted against other methodologies that have historically required accompanying use of two-dimensional (2D) engineering drawings, for example, to provide such information.

The phrase "model-based definition environment" refers to a computer-implemented environment wherein data from and about a 3D virtual model can be accessed, typically via a user interface on a computer display, in a model-based definition fashion.

The term "cropping" refers to a process whereby a first portion of an individual component or product assembly in an image is removed or hidden from view while a second portion of the individual component or product assembly remains intact and visible within the image. A "cropped view" is a view produced by cropping. Certain cropped views may be considered detail views.

The phrase "model detail view" refers to a visual depiction showing at least a portion of a model and may be or include a cropped view. The portion of the model may be, for example, an orthographic view, a non-planar (isometric) view, a section view, a crop view, an exploded assembly view, or another detail view. The model detail view typically appears on a computer display via a user interface but may of course be printed as well. The model detail view may be shown at an enlarged scale relative to the original model.

The phrase "processor" or the like refers to any one or more computer-based processing devices. A computer-based processing device is a physical component that can perform computer functionalities by executing computer-readable instructions stored in memory.

The phrase "memory" or the like refers to any one or more computer-based memory devices. A computer-based memory device is a physical component that can store computer-readable instructions that, when executed by a processor, results in the processor performing associated computer functionalities.

### Related Technologies

Within the 2D drawing environment, detail views and crop views provide a method to isolate geometries from a full representation of a product to allow for focus on certain geometries for clearer product definition. Such representations typically are limited to 2D environments and generally only available within drawing sheets or similarly 2D-constrained environments.

Dassault Systemes' SOLIDWORKS^{®} computer software has a concept that enables the creation of a Model Break View, which has its own methods to represent a traditionally 2D concept of a Model Break View within a 3D environment for display within that environment and subsequently within in a 2D environment on a drawing sheet. This method is specific to break view equivalency and provides no method for geometry isolation to fulfill the needs of 3D equivalents for concepts of detail views and crop views in a model-based definition (MBD) environment. New systems and methods, disclosed herein, support these other types of views in 3D.

Current functionality allows drafters to create a presentation that stores a specific orientation, zoom level and center of view. This allows the drafter to create a presentation state that is zoomed in and focused on a specific location on the product. However, this does not allow for the isolation of specific geometry to provide clear focus for the product definition of that geometry within MBD environment in the same manner as available by detail views and crop views on a 2D drawing sheet.

The systems and techniques disclosed herein differ from prior approaches in technical approach, execution, and output and overcome or at least significantly minimize the technical limitations of prior systems and approaches. Other technical differences may exist between various prior technologies and the systems and techniques disclosed herein.

### Technical Disclosure

As CAD modeling, including the field of Model-based Definition (MBD), expands, new methods become desirable for displaying product definition information for 3D models (e.g., of mechanical components) within environments where 2D representations are either eliminated or relegated to a secondary role. In this regard, it is desirable for MBD implementations to provide modern 3D equivalents for display concepts used on 2D representations in the past.

A detail view is generally a type of drawing view that is defined by international standards such as ISO and ASME within the context of 2D representation as a type of drawing view on a drawing sheet. A detail view allows for a particular portion of the 2D representation of a product to be isolated and removed from the full representation of that product. Such isolation allows the drafter to create a drawing view that focuses on particular geometry while removing potential clutter from other geometry and elements that may crowd the 2D representation. A detail view also generally allows for enlargement of the isolated geometry in order to increase the amount of space that the view occupies on the sheet, which provides more space for product definition elements such as visual detail, dimensions, and other annotation, without crowding these elements. Detail views are typically not used to the exclusion of a full representation of the product but are often segmented copies of a portion of the full representation that are shown separately on the same drawing sheet, but still retain a reference to the original drawing view from which they were derived. All of this allows the drawing to display product definition (typically in the form of dimensions and other annotations) in a focused, uncluttered and better organized manner.

A crop view may be considered a type of drawing view that is also defined by international standards of ISO and ASME within the context of 2D representation. A crop view is similar to that of detail view. One difference between a crop view and a detail view is that a crop view is used to crop a full representation of product generally without a direct reference to any other drawing view. Commonly, crop views are not enlarged, but achieve the same results as detail views showing the isolated geometry by similarly excluding geometry from the view. This method is often used for long components where only one end is necessary to product definition within the view, or symmetric components where half the full representation may be removed, and it is understood that the shown half represents both sides of the product. As such, crop views are often used to save space and simplify product representation on a drawing.

Though MBD generally applies annotations and other product definition directly to a 3D CAD model itself (without the use of drawings) and does not require 2D representation, a method to provide geometric isolation and product display simplification within the MBD environment (an environment where a 3D model is available for query and where product definition, such as dimensions and other annotations, can be applied) is desirable to allow the drafter to provide product definition information, for example, which focuses on particular geometries to the exclusion of other geometries which may interfere or otherwise limit human-readability of such product definition. Basically, there is a need within MBD for a 3D representation equivalent to the 2D representations known as detail views and crop views.

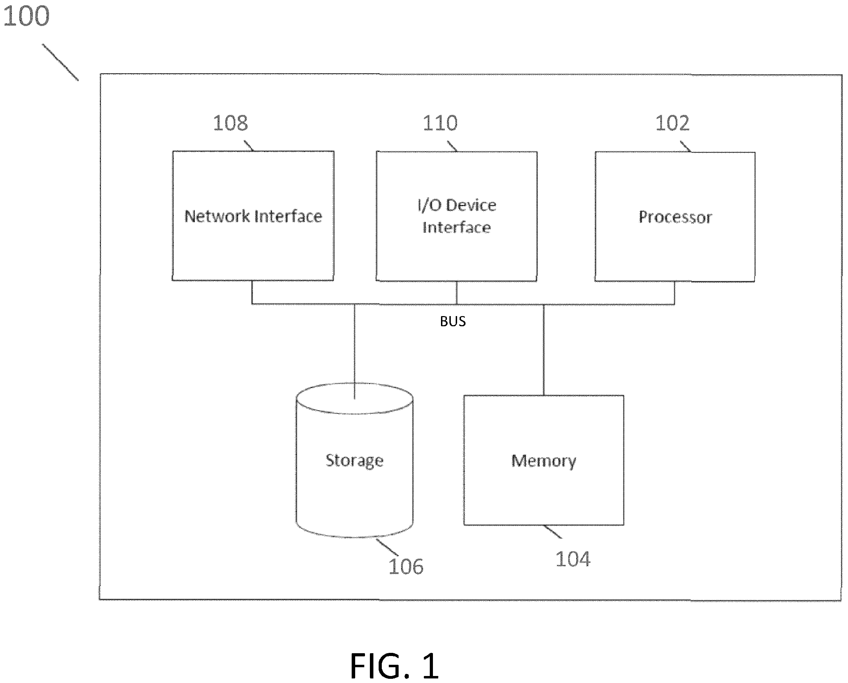

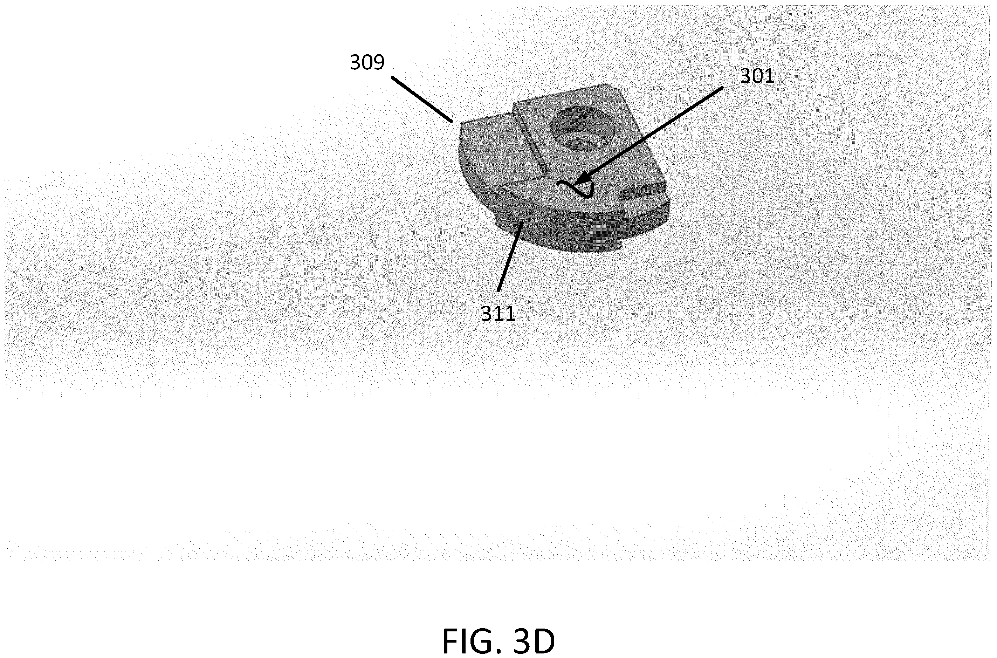

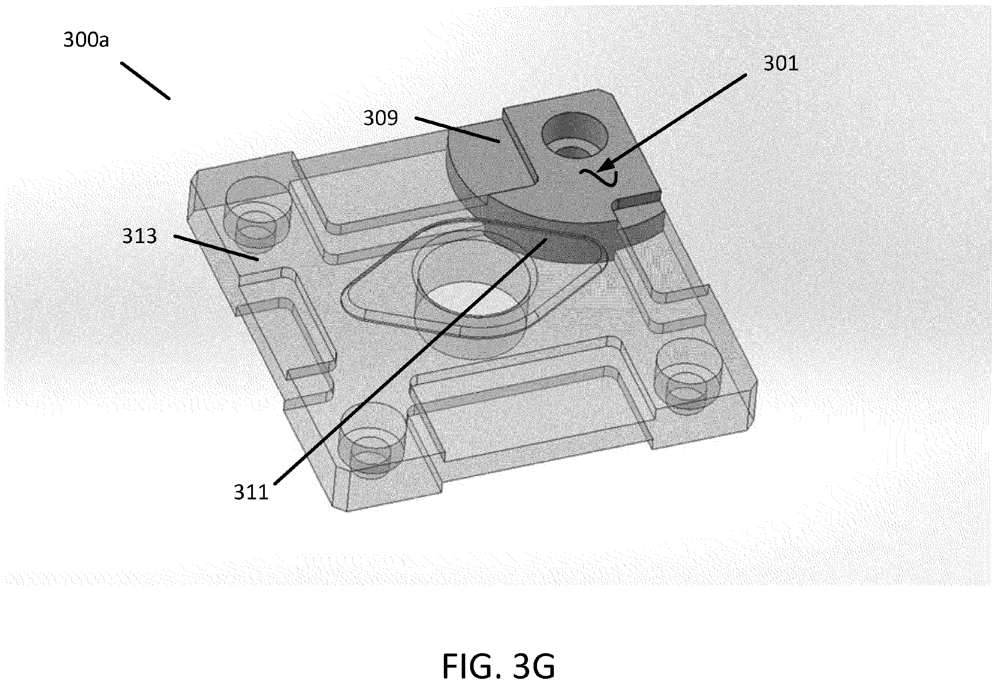

FIG. 1 is a schematic representation of an exemplary computer 100 configured to generate a cropped visual representation of a computer-aided design (CAD) three-dimensional (3D) model of an object to be manufactured. There are a variety of ways in which the cropped representation may appear on a computer display device. For example, in some implementations, the cropped representation may appear with any excluded geometry hidden (e.g., as in FIG. 3D) or having a distinct appearance (e.g., transparent with only edges visible) relative to any portions of the model visible in the cropped representation (which may be shown as a solid) (e.g., as in FIG. 3G). Other variations are possible.

Referring again to FIG. 1, the computer 100 has a processor 102, computer-based memory 104, computer-based storage 106, a network interface 108, an input/output device interface 110, and a bus that serves as an interconnect between the components of the computer 100. The bus acts as a communication medium over which the various components of the computer 100 can communicate and interact with one another. The computer 100, in a typical implementation, is configured to perform various functionalities including, for example, generating a cropped representation showing a portion of a CAD 3D model, as described herein. The components 100 of the computer 100 typically interact with one another (and, potentially, with one or more external components) to perform and/or facilitate the performance of such functionalities.

The processor 102 is configured to perform the various computer-based processing functionalities disclosed herein and other functionalities as well. Typically, the processor 102 performs these functionalities by executing computer-readable instructions stored on a computer-readable medium (e.g., in 104 or 106). In various implementations, some of these functionalities may be performed with reference to data stored in the computer-readable medium and/or data received from some external source (e.g., an input / output (I/O) device via the I/O device interface 110 and/or from an external network via the network interface 108).

The computer 100 has volatile and non-volatile memory. More specifically, in a typical implementation, memory 104 provides a form of volatile storage storing computer-readable instructions that, when executed by the processor 102, cause the processor 102 to perform or facilitate some (or all) of the computer-based functionalities disclosed herein. Moreover, in a typical implementation, storage 106 provides a form of non-volatile memory storing computer-readable instructions, such as instructions to implement an operating system, configuration information, etc. The various system memory resources (e.g., 104, 106) may store data and other computer-readable information, as well.

More specifically, in a typical implementation, the memory 104 stores computer-readable instructions that, when executed by the processor 102, cause the processor 102 to execute functionalities that cause the computer 100 to present to a user at the computer 100 a computer-aided design program, with the functionalities disclosed herein incorporated therein. An example of a computer-aided design program that can be adapted to incorporate the functionalities disclosed herein is the SOLIDWORKS^{®} computer program, available from Dassault Systèmes SolidWorks Corporation, the applicant of the current application. The computer-aided design program, so adapted, would include the ability to generate a cropped representation of a CAD three-dimensional model by implementing processes disclosed herein.

The network interface 108 is a component that enables the computer 100 to connect to any one or more of a variety of external computer-based communications networks (and connected equipment), including, for example, local area networks (LANs), wide area networks (WANs), such as the Internet, or the like. In various implementations, the network interface 108 can be implemented in hardware, software, or a combination of hardware and software.

The input/output (I/O) device interface 110 is a component that enables the computer 100 to interface with any one or more input or output devices, such as a keyboard, mouse, display, microphone, speakers, printers, manufacturing machines (e.g., a computer numerical control (CNC) machine), etc. In various implementations, the I/O device interface can be implemented in hardware, software, or a combination of hardware and software. In a typical implementation, the computer may include one or more I/O devices (*e.g.,* a computer screen, keyboard, mouse, printer, touch screen device, CNC machine, etc.) connected to the I/O device interface 110. These I/O devices (not shown in FIG. 1) act as human-machine-interfaces (HMIs) and are generally configured enable a human user to interact with the system 100 to access and utilize functionalities, particularly those related to computer-aided design, and generating a cropped representation of a 3d model in a CAD environment (e.g., as provided in the SOLIDWORKS^{®} computer program).

In an exemplary implementation, the computer 100 is connected to a display device (e.g., via the I/O device interface 110) and configured to present at the display device a visual representation of an interface to a product design environment, such as the one provided by and within the SOLIDWORKS^{®} computer program. The interface and its visual representation on the computer-based display device, in a typical implementation, provides the user with access to the functionalities disclosed herein, and displays (e.g., on a display device coupled to the I/O device interface 110) a visual representation of an original 3D model, as well as a computer-generated cropped representation of the original 3D model typically generated in accordance with user-specified crop contours. The interface and its visual representation on the computer-based display device display also typically provides the user with access to functionalities (though buttons, menus, pointers, and other on-screen widgets) to facilitate user interaction with the computer 100 in a manner that initiates and implements the functionalities disclosed herein.

In some implementations, the computer 100 and its various components may be contained in a single housing (e.g., as in a personal laptop) or at a single workstation. In some implementations, the computer 100 and its various components may be distributed across multiple housings, perhaps in multiple locations on a network. Each component of the computer 100 may include multiple versions of that component, possibly working in concert, and those multiple versions may be in different physical locations and connected together via a network. For example, the processor 102 in FIG. 1 may represent multiple discrete processors in one or more different physical locations and/or housings working together to perform processes attributable to the processor 102 in a coordinated manner. A wide variety of possibilities regarding specific physical implementations are possible.

In various implementations, the computer 100 may have additional elements not shown in FIG. 1. These can include, for example, controllers, buffers (caches), drivers, repeaters, receivers, etc. Furthermore, the interfaces (e.g., 108, 110) may include elements not specifically represented in FIG. 1, including, for example, address, control, and/or data connections to facilitate communications between the illustrated computer components.

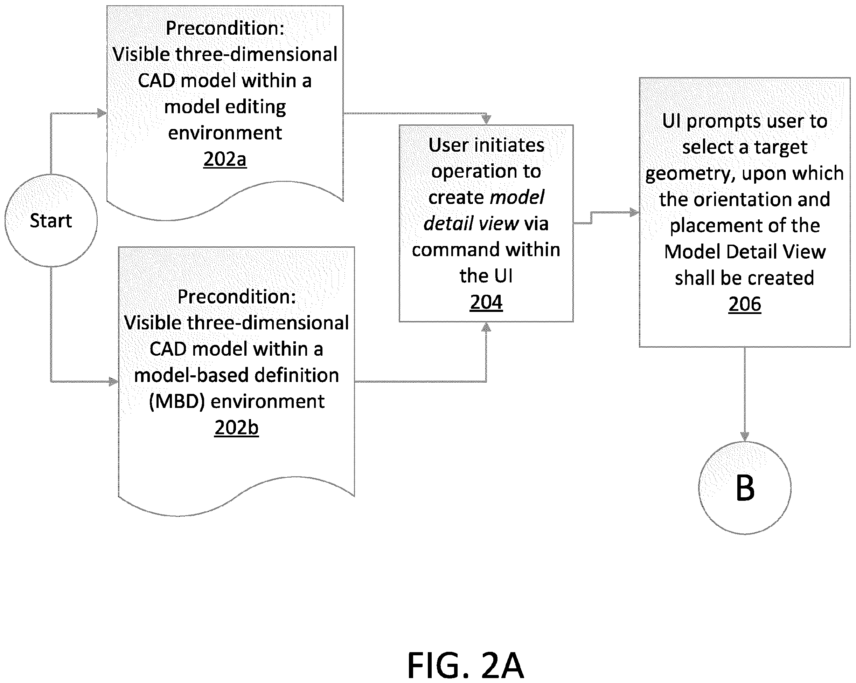

FIGS. 2A-2H is a flowchart that represents an exemplary computer-implemented method that may be integrated into the design of a modeled object to be manufactured. More specifically, the method represented in the illustrated flowchart generates a cropped representation of the modeled object from a 3D model thereof to provide easy access to manufacturing details of the modeled object to facilitate manufacturing thereof. In an exemplary embodiment, the illustrated method may be implemented using the computer 100 of FIG. 1.

Referring to FIG. 2A, the illustrated method begins at start, at which point a three-dimensional (3D) CAD model of an object to be manufactured has been created and is being stored in memory on the computer 100. At this point in the process, according to the illustrated flowchart, one of two potential preconditions exist: either the 3D model is visible on the computer display within a model editing environment 202a or within a model-based definition (MBD) environment 202b.

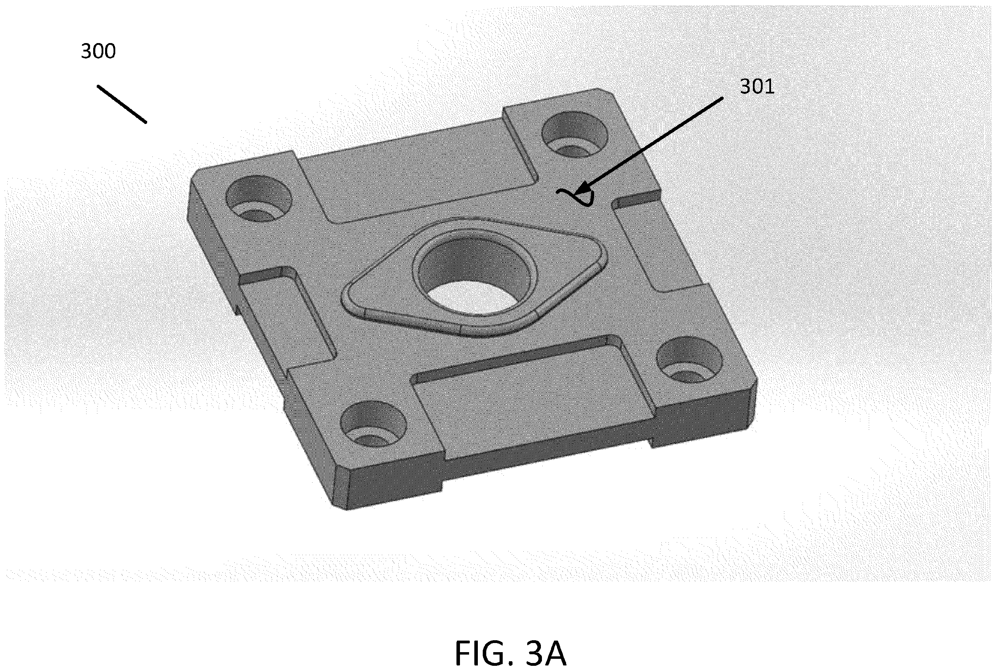

FIG. 3A shows an example of a visual depiction 300 of an exemplary object represented by a virtual 3D model. The virtual 3D model is an example of one stored in computer memory at the start of the FIG. 2A process and may appear on screen in the process represented in the FIG. 2A flowchart, for example, as shown in FIG. 3A. The object represented by the virtual 3D model is one to be manufactured, based on the modeled information. The object has a square shaped outline with chamfered corners, a larger circular opening in its center, and four smaller and countersunk circular openings, one in each corner of the object. On a top side of the object (visible in FIG. 3A), a diamond shaped platform with rounded corners surrounds the larger circular opening. Additionally, four recesses are provided, each one being positioned along a corresponding one of the edges of the object between adjacent corners. In each recess, two of the inner corners are rounded and the outer edge of the recess extends to the outer edge of the object.

In an exemplary implementation, the object shown in FIG. 3A may be the 3D model that appears as a visual depiction on the computer screen (at 102a or 202b in FIG. 2A).

Next, according to the process represented in the flowchart of FIG. 2A, a human user (at 204) initiates an operation to create a model detail view (e.g., cropped view of the visible object) by entering a command through the user interface presented on the computer display. In some implementations, the user may enter the command by interacting with or selecting an on screen graphical control element (e.g., a button, an option in a context menu, etc.) to initiate the indicated operation.

Next, in response to the user initiating action, the computer 100 (at 206) prompts the user to select a target geometry (e.g., from the modeled object appearing on the computer display), from which the model detail view will be generated. There are a variety of ways in which the computer 100 may prompt the user in this regard. In some implementations, for example, the user interface may present a textual message on the computer's display instructing the user to select a target geometry (e.g., from the object displayed onscreen).

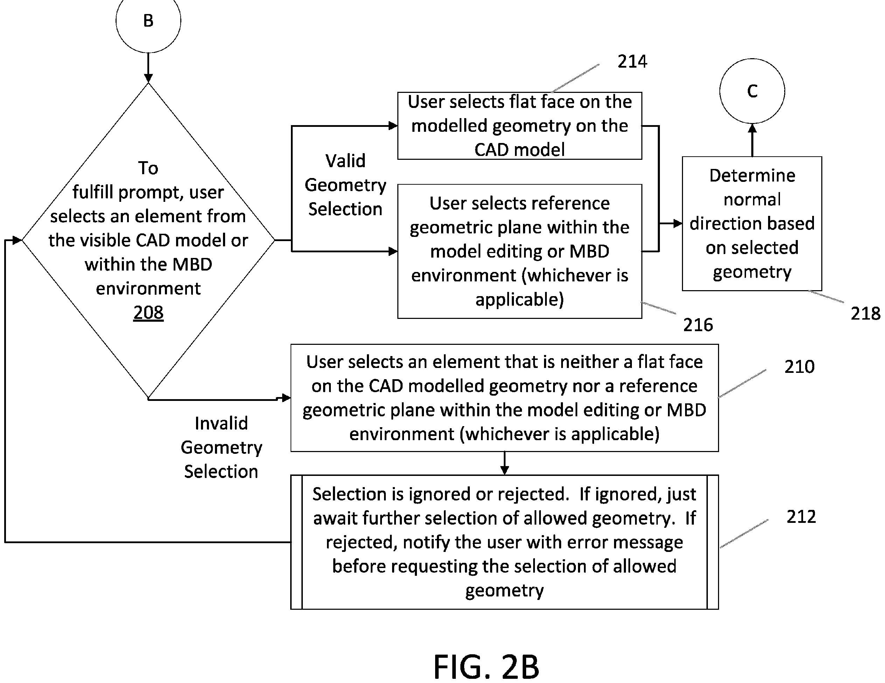

Referring now to FIG. 2B, the user (at 208), selects an element from the visible CAD model or within the MBD environment, in response to the onscreen prompt. In various implementations, the user may be able to select the target geometry (e.g., an element from the model) in any one or more of a variety of possible ways. In one example, the user would manipulate his or her mouse to position an onscreen cursor at a particular onscreen position that corresponds to a particular geometry (e.g., a flat face) that forms part of the visible model. Once positioned in this manner, the computer 100 may present the particular geometry in a visually distinct manner relative to the rest of the visual depiction 300 of the modeled object to indicate to the user that the particular geometry is subject to being selected as a target geometry. Next, the user may press a button or other touch sensor (e.g., on the mouse) to select the particular geometry associated with the onscreen position of the cursor and, thereby, designate the particular geometry as the target geometry. Once designated, the computer 100 may provide feedback to the user (e.g., onscreen as a message or visually within the visual depiction 300 of the modeled object) that the particular geometry has been so designated. In a typical implementation, the computer 100 also saves the designation to memory.

In a typical implementation, the designated target geometry, selected by the user at 208, serves as a reference geometry in the onscreen modeled object from which the model detail view is generated during subsequent steps in the indicated process. More specifically, this reference geometry may define a reference plane upon which the user may define (e.g., position, orient, shape, and size) a boundary for use in defining a portion of the model to be isolated.

The computer 100, in a typical implementation, is configured to check whether the geometry selected by the user (at 208), is a valid selection for purposes of serving its intended role within the indicated process. In one exemplary implementation, the selected geometry may be treated by the computer 100 as a valid selection if it is a flat face on the modeled geometry on the CAD model or a geometric plane; otherwise, the selected geometry may be treated as an invalid selection. In various implementations, the computer 100 may apply different criteria to validate or invalidate the user's selected geometry as a target geometry for the indicated process.

According to the process represented in FIG. 2B, the computer 100 determines, using the foregoing selection criteria, whether the selected geometry is valid or not. If, the computer 100 determines (see 210) that the selection was an invalid geometry selection (e.g., that the user selected an element that was neither a flat face on the CAD modeled geometry nor a reference geometric plane that defines the shape or form of a surface or a solid for example within the model editing or MBD environment), then the computer 100 (at 212) either ignores or rejects the selection.

If the computer 100 (at 212) ignores the selection, then the computer 100 does not respond to the user's selection, but simply waits for the user to select a different geometry (at 208) and then determines whether that different geometry is a valid selection. If the computer (at 212) rejects the selection, the computer 100 notifies the user that the selection is invalid (e.g., with an onscreen error message) and prompts the user to make a different selection. The process then returns to 208 where the computer 100 awaits a further selection by the user and determines its validity.

FIG. 3A identifies an example of a selected geometry (at 301) that the computer 100 may deem valid. The selected geometry 301 in the illustrated example is the flat upper face that surrounds one of the corner holes in the illustrated 3D model.

Referring again to the flowchart of FIG. 2B, if the computer 100 determines that the geometry selected by the user (at 208) is valid (e.g., that the user as selected either a flat face on the modeled geometry on the CAD model at 214 or a reference geometric plane within the model editing or MBD environment at 216), then the computer 100 next (at 218) determines a normal direction based on the selected geometry. More specifically, in a typical implementation, the computer 100 (at 218) determines a direction that is normal to a plane of the flat surface or reference geometric plane selected by the user (at 208) and validated by the computer 100 (at 214, 216). In a typical implementation, the computer 100 may call on a "normal to" function to identify a normal to the surface/plane (e.g., in one or both directions). If only one direction, the "normal to" direction would be the determined to be a normal direction into the modeled object.

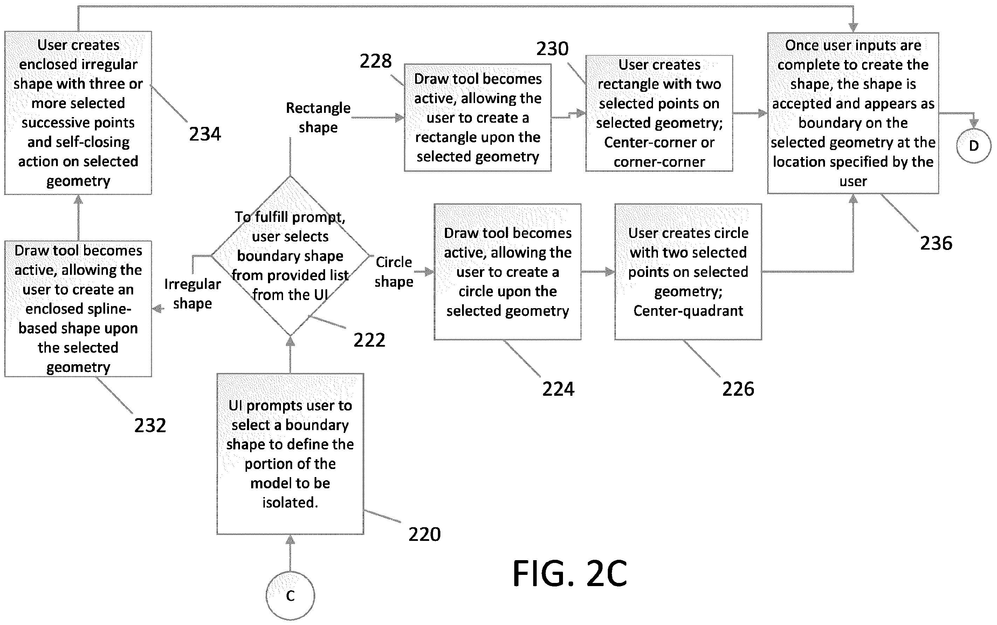

Referring now to FIG. 2C, the user interface of the computer 100 (at 220) prompts the user to select a boundary shape to define the portion of the model to be isolated. The computer 100 may prompt the user in this regard in any number of potential ways. In one example, the computer 100 may present an onscreen list (e.g., as part of an onscreen menu) of user-selectable elements, each of which identifies and corresponds to a particular type of boundary shape that the user may select to define the portion of the model to be isolated. The available boundary shapes may include, for example, a circle shape, a rectangular shape, or an irregular shape. In various implementations, other shapes and/or combinations of available shapes may be presented to the user onscreen at 220.

To fulfill the prompt presented by the computer at 220, the user (at 222) selects one of the boundary shapes presented to the user by the computer 100. If the user (at 222) selects the circle shape option, then the computer's draw tool becomes active (at 224). This allows the user to create (draw) a circle on the geometry that the user selected (at 208) and that was deemed valid by the computer 100. Next, the user (at 226) creates the circle. According to the illustrated implementation, the user performs this function by designating (e.g., through mouse manipulation of an onscreen cursor) two onscreen points, in a center-quadrant designation process. Other ways of creating / drawing a circle are possible. If the user (at 222) selects the rectangle shape option, then the computer's draw tool becomes active (at 228). This allows the user to create (draw) a rectangle on the geometry that the user selected (at 208) and that was deemed valid by the computer 100. Next, the user (at 230) creates the rectangle. According to the illustrated implementation, the user performs this function by designating (e.g., through mouse manipulation of an onscreen cursor) a center and a corner or a corner and another corner. Other ways of creating / drawing a rectangle are possible. If the user (at 222) selects the irregular shape option, then the computer's draw tool becomes active (at 232). This allows the user to create (draw) an enclosed spline-based shape on the geometry that the user selected (at 208) and that was deemed valid by the computer 100. Next, the user (at 230) creates an enclosed irregular shape. According to the illustrated implementation, the user performs this function by designating (e.g., through mouse manipulation of an onscreen cursor) three or more selected successive points and self-closing action on the selected geometry. Other ways of creating / drawing an irregular shape are possible. In each way, the user is presented with functionality that enables the user to locate, size, and configure the shape on the selected geometry.

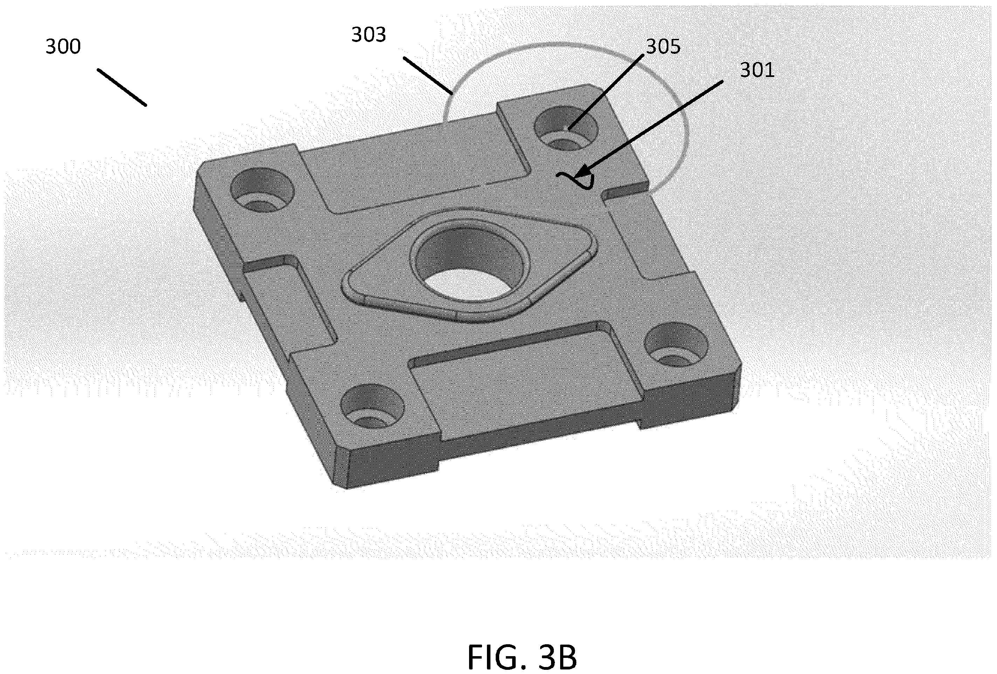

After the user takes steps to complete the necessary inputs to create a selected shape on the selected and validated geometry (at 226, 230, or 234), the computer 100 (at 236) accepts the shape and presents it onscreen as a boundary on the selected geometry at the location specified by the user. FIG. 3B shows the visual depiction 300 of the exemplary object from FIG. 3A with a circle 303 (having been created by a user) on the selected geometry 301. More specifically, the circle 303 in the illustrated example is formed on (and sits entirely in the same plane as) the previously selected flat upper face that surrounds one of the corner holes in the illustrated 3D model. The center 305 of the circle 303 is visible as is its outline. Moreover, the center 305 of the circle 303 is located above the corner opening that the circle 303 surrounds. A first part of the outline of the circle 303 is above a part of the object in the illustrated 3D model, but a second part of the outline of the circle 303 extends past the edges of the object and, therefore, is not above any part of the object in the illustrated 3D model.

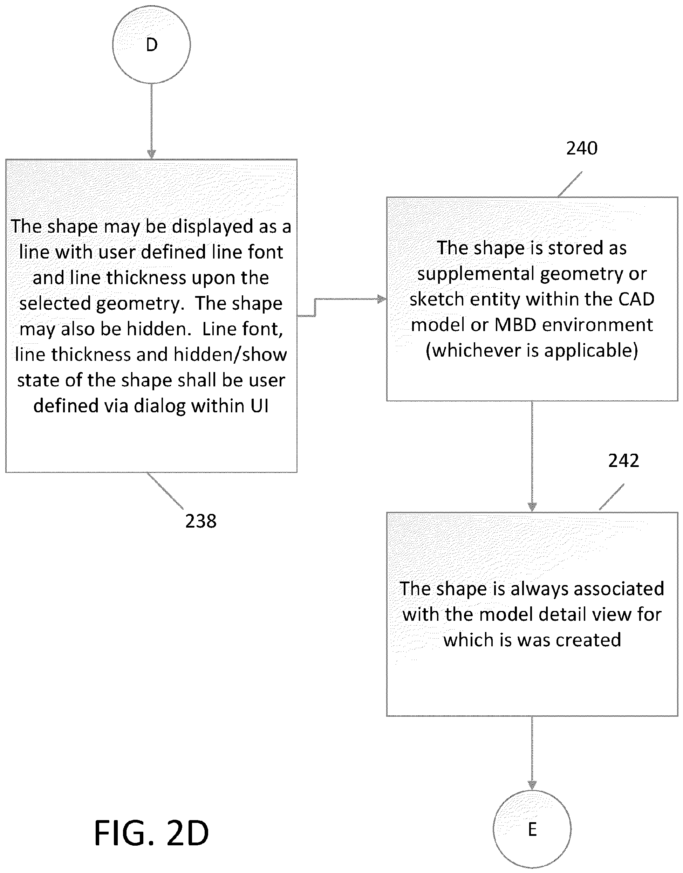

Referring now to FIG. 2D, the flowchart indicates (at 238) that the computer 100 may display the shape (e.g., the circle in FIG. 3B) with user-defined line font(s) and user-defined line thicknesses upon the user-selected geometry. Moreover, the flowchart (still at 238) indicates that the computer 100 may, in some implementations, hide the shape. In such cases, the computer 100 may display the object (e.g., as shown in FIG. 3A), but hide the shape (e.g., circle 303 in FIG. 3B) from view, even though the shape has been created (e.g., fully specified by the user and finalized by the computer 100). The flowchart (again, still at 238) further indicates that the user interface of the computer 100 may provide to the user a dialogue, for example, that enclosed the user to specify these details (e.g., line font, line thickness, hidden/visible status, etc.) of the shape. In various implementations, the shape, according to the flowchart (at 240), may be stored in the computer 100 as supplemental geometry (e.g., an object type within a data model) or a sketch entity within the CAD model or MBD environment, whichever is applicable. Moreover, according to the illustrated flowchart (at 242), the computer 100 stores the shape in a manner such that it is always logically associated with the model detail view for which the shape has been created.

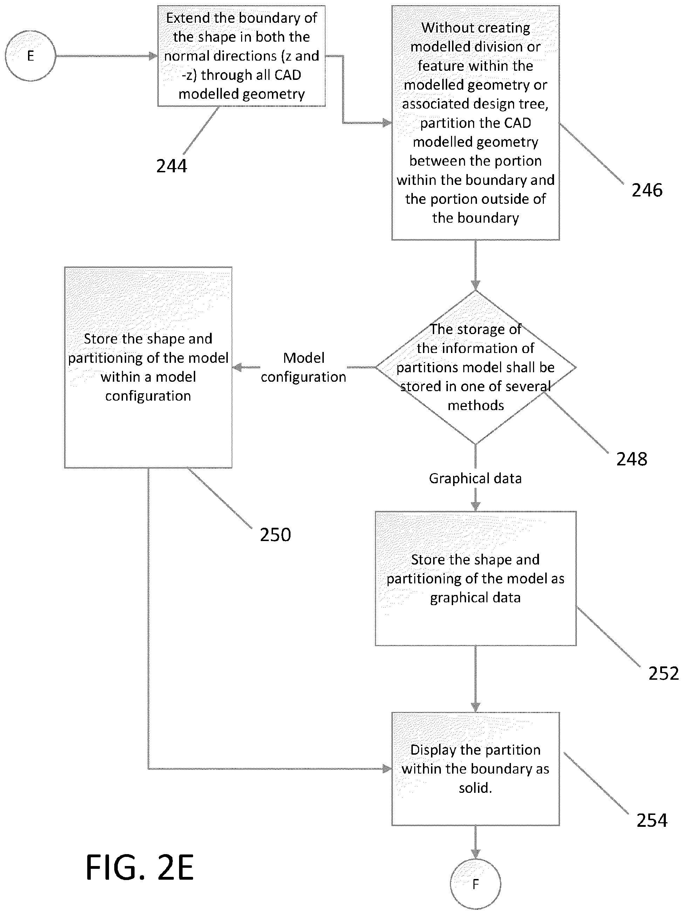

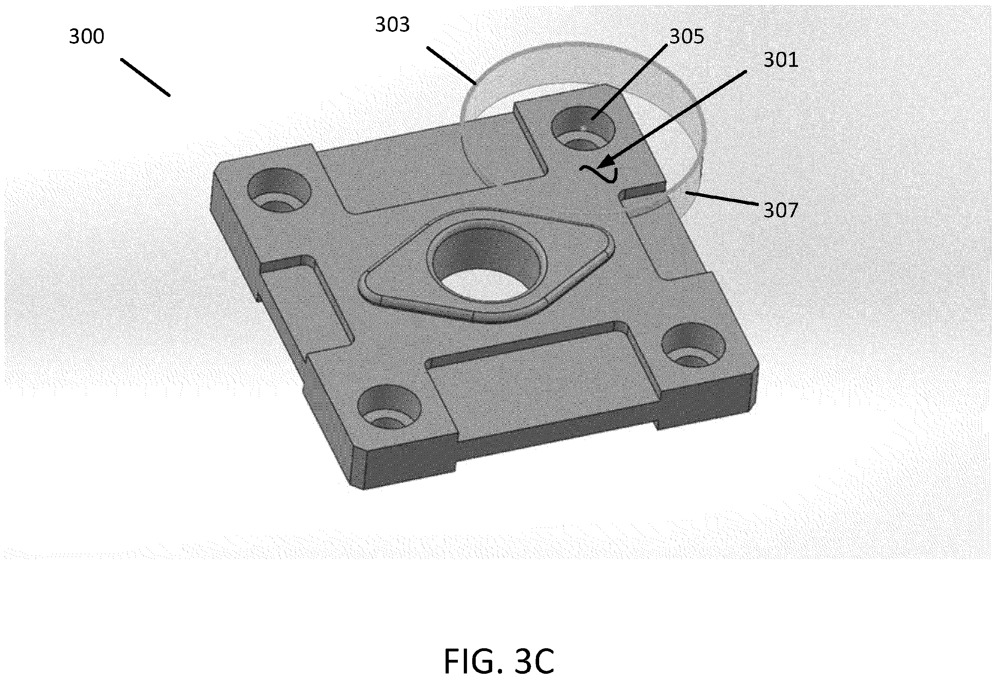

Referring now to FIG. 2E, next, the computer 100 (at 244) extends the boundary of the shape in one or more normal directions (z and/or -z) at least through the CAD modeled geometry. FIG. 3C illustrates this concept schematically. More specifically, the image in FIG. 3C, which the computer 100 typically presents to the user visually on the computer display, shows the visual depiction 300 of the modeled object from FIG. 3B, but with the user-specified shape 303 (specified at step 222) having been extended in a normal direction relative to the flat upper face of the user-selected geometry 301 to produce a 3D extended shape 307. In an exemplary implementation, the computer 100 utilizes the normal direction(s) determined at step 218 to direct the extension(s) of the boundary of the shape (at 244). In the example shown in FIG. 3C, the 3D extended shape 307 passes through the entirety of the CAD modeled geometry from the flat upper face selected geometry 301 (selected by the user at step 208) in a downward (-z) direction. In a typical implementation, the computer 100 displays the resulting extended shape 307 onscreen, as shown, so that the user can see its location and orientation relative to the visual depiction 300 of the modeled object as it is created. The 3D extended shape 307 has a first portion that passes through the modeled object in the visual depiction 300 and a second portion entirely outside the modeled object in the visual depiction 300. The first portion of the 3D extended shape 307 defines a cut pattern for the cropped representation being produced. The second portion of the 3D defined shape 307 is not relevant to defining the cut pattern for the cropped representation being produced. According to the illustrated example, since the user defined a 2D circle (at step 222 in FIG. 2C), the computer 100 generates (at 244) a 3D extended shape that is a hollow cylinder. If the user (at step 222) defines a different type of 2D shape (e.g., a rectangular shape or irregular shape) or even line segment, then the computer-generated 3D extended shape (generated at 244) will be a 3D shape other than a hollow cylinder.

Referring again to FIG. 2E, next, according to the illustrated flowchart, the computer 100 (at 246) partitions the CAD modeled geometry (e.g., represented in visual depiction 300) into two portions including a first portion within the boundary of the 3D extended shape (generated at 244) and a second portion outside the boundary of the 3D extended shape. As indicated in the illustrated flowchart, the computer 100 typically performs this step (at 246) without creating a modeled division or a feature within the modeled geometry or an associated design tree.

Instead, as indicated in the attached flowchart (see 248), the storage of information related to partitioning of the model may be stored using either a model configuration method or a graphical data method. When utilizing the model configuration storage method (see 250), the computer 100 stores the shape and partitioning of the model (e.g., information about the partitioned model) within a model configuration. This is the same manner in which *Model Break Views* are stored within the modelling environment of the desktop version of the SOLIDWORKS^{®} computer program. More specifically, in some implementations, the shape and partitioning of the model may be stored by the computer as configurations, which may enable users to create multiple variations of a part or assembly model within a single document. When utilizing the graphical data storage method (see 252), the computer 100 stores the shape and partitioning of the model as graphical data. This is the same manner in which *Section Views* are stored within the modelling environment of the desktop version of the SOLIDWORKS^{®} computer program (e.g., as a view orientation to quickly recall it in a part environment or as a Drawing Annotation View).

Next, the computer 100 displays the partitioned model. There are a variety of ways in which the computer 100 may perform this function.

In a typical implementation, the computer 100 enables the user to select any one of a plurality of options for displaying the partitioned model (or relevant parts thereof) and/or portions thereof. For example, in some implementations, the computer 100 may be configured to display the first portion of the partitioned model (i.e., the portion within the boundary of the 3D extended shape), while hiding from view the second portion of the partitioned model (i.e., the portion outside the boundary of the 3D extended shape). Alternatively, in some implementations, the computer 100 may be configured to display the partitioned model in a manner that shows the first and second portions of the partitioned model in a manner that visually distinguishes the first portion of the partitioned model from the second portion of the partitioned model.

Thus, there are a variety of ways in which the computer 100 may display the partitioned model (or portions thereof) to facilitate a full understanding of the modeled object for purposes of refining the design and/or manufacturing a corresponding real world product utilizing one or more real world machines. However, according to the illustrated implementation,. the computer 100 (at 254 in FIG. 2E) displays the portion of the partitioned model within the boundary, including the boundary itself, as a solid surface.

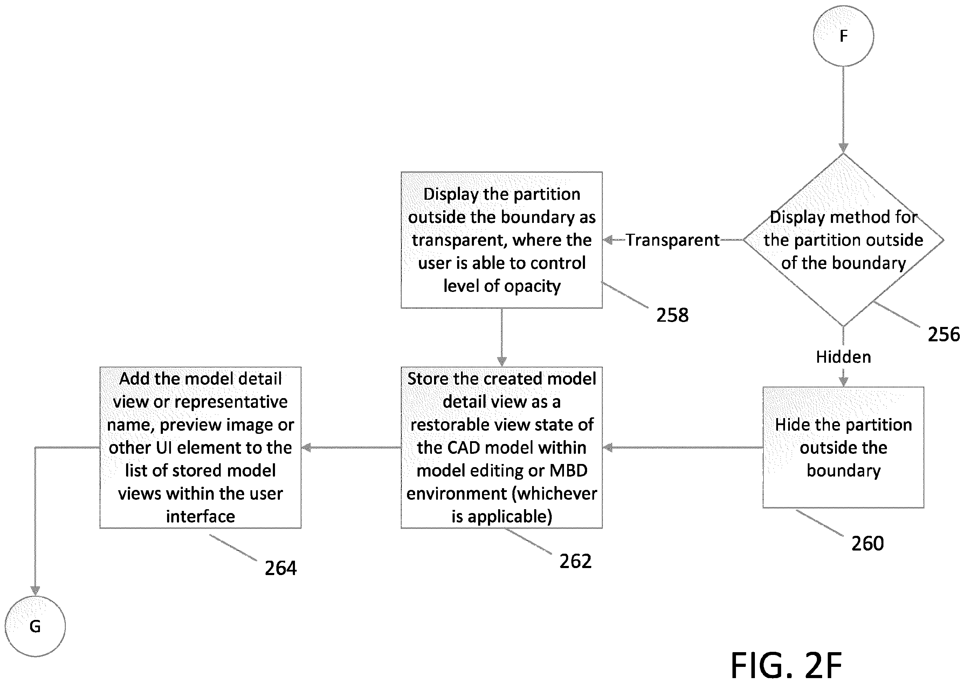

Referring now to 256 in FIG. 2F, the computer 100 enables the user to select among candidate display methods for the second portion of the partitioned model (i.e., the portion outside the boundary). The candidate methods represented in the illustrated flowchart include displaying the second portion of the partitioned model (outside the boundary) as transparent (at 258) or hiding the second portion of the partitioned model (at 260). If the user chooses the transparent option, the computer 100 may display an outline of the second portion of the partitioned model with the surfaces of the second portion of the partitioned model between the outline lines being transparent. This enables the user to see, on the computer display, the inner surface of the modeled object at the boundary through the transparent second portion of the modeled object. In an exemplary implementation, if the user selects the transparent option (at 256), the computer 100 may enable the user to control the level of opacity of the transparent second portion of the modeled object.

FIG. 3D shows an example of an image that may appear on the display if the computer 100 displays the first portion 309 of the partitioned model (i.e., the portion within the boundary of the 3D extended shape), while hiding from view the second portion of the partitioned model (i.e., the portion outside the boundary of the 3D extended shape). The boundary at the inner edge of the first portion 309 of the partitioned model is represented as a solid, opaque surface 311. In fact, in the illustrated implemented, the entirety of the first portion 309 of the partitioned model, including the boundary at the inner edge thereof, is represented with solid, opaque surfaces.

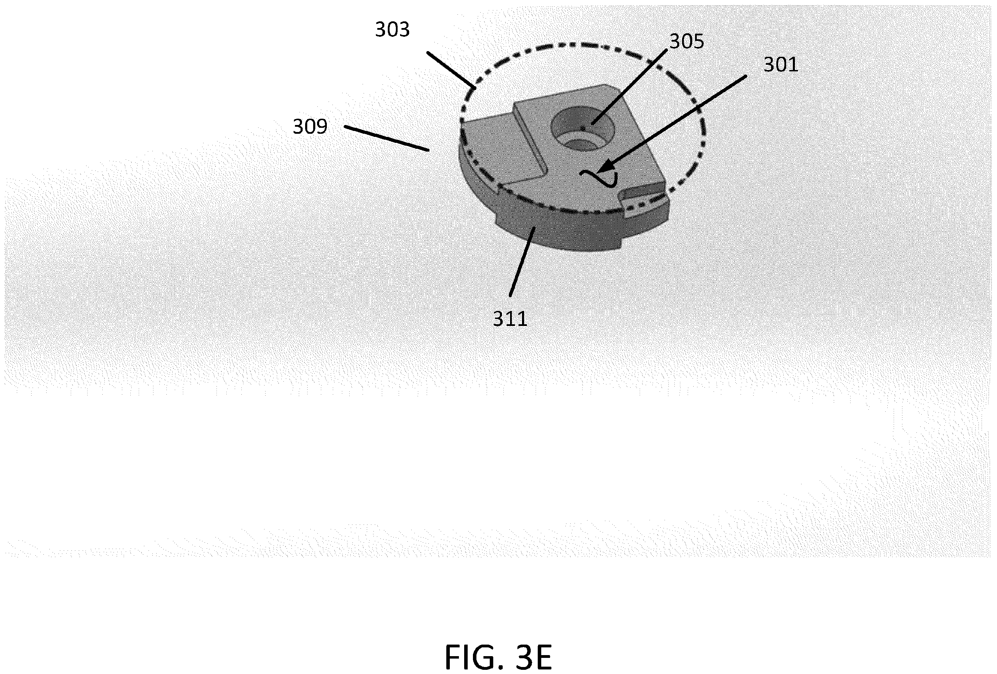

FIG. 3E shows another example of an image that may appear on the display if the computer 100 displays the first portion 309 of the partitioned model (i.e., the portion within the boundary of the 3D extended shape), while hiding from view the second portion of the partitioned model (i.e., the portion outside the boundary of the 3D extended shape). The image in FIG. 3E is similar to the image in FIG. 3D except that the image in FIG. 3E not only shows the first portion 309 of the partitioned model and the boundary at the inner edge as solid surface 311, but it also shows the circle 303 (with dashed lines) on the selected geometry (i.e., the flat face 301) and the center 305 of the circle identified with a dot. Again, in the illustrated implemented, the entirety of the first portion 309 of the partitioned model, including the boundary at the inner edge thereof, is represented with solid, opaque surfaces.

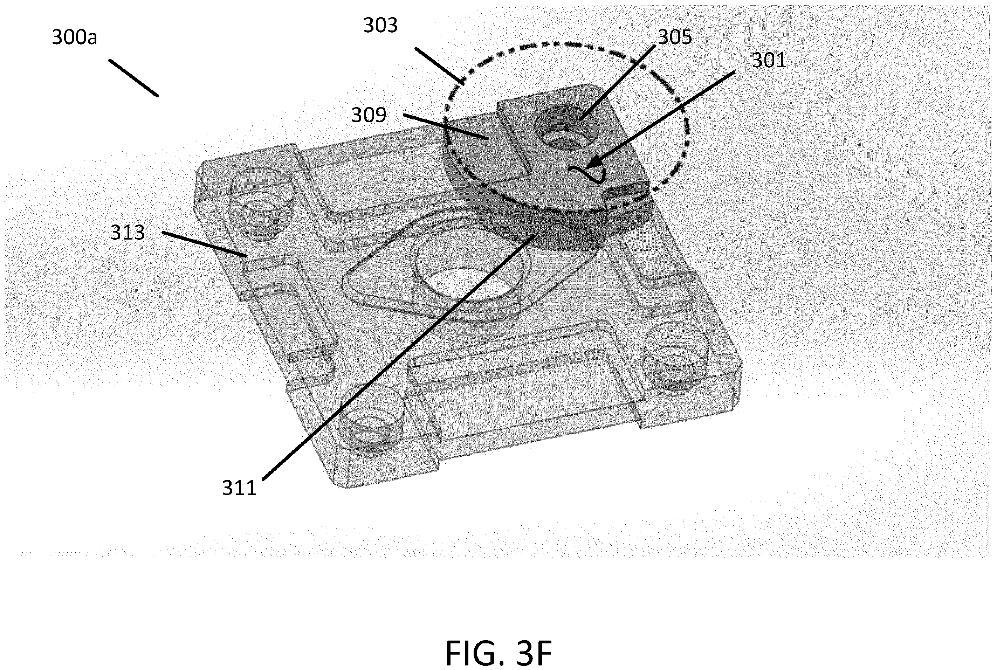

FIG. 3F shows an example of an image that may appear on the display if the computer 100 displays the first and second portions of the partitioned model 300a together in a manner that visually distinguishes the first portion 309 of the partitioned model 300a (i.e., the portion within the boundary of the 3D extended shape) from the second portion 313 of the partitioned model 300a (i.e., the portion outside the boundary of the 3D extended shape). The first portion 309 of the partitioned model 300a appears in FIG. 3F in much the same manner as the first portion 309 of the partitioned model appeared in FIG. 3E. More specifically, the first portion 309 of the partitioned model 300a in FIG. 3F appears with its entirety, including the boundary at its inner edge, represented with solid, opaque surfaces, and with the circle 303 superimposed in the form of dashed lines on the selected geometry (i.e., flat face 301) and the center 305 of the circle identified with a dot. The second portion 313 of the partitioned model 300a in the illustrated example is visually distinguished from the first portion 309 of the partitioned model 300a by being / visually appearing transparent or see-through. The see-through second portion 313 of the partitioned model 300a in the illustrated example enables a user to clearly see the solid, opaque cross-sectional interior surface 311 at the boundary 311 of the first and second portions of the partitioned model 300a.

FIG. 3G shows another example of an image that may appear on the display if the computer 100 displays the first and second portions of the partitioned model 300a together in a manner that visually distinguishes the first portion 309 of the partitioned model 300a (i.e., the portion within the boundary of the 3D extended shape) from the second portion 313 of the partitioned model 300a (i.e., the portion outside the boundary of the 3D extended shape). The image in FIG. 3G is similar to the image in FIG. 3F, except that the image in FIG. 3G does not include the circle 303 or the dot at the center 305 of the circle.

Referring again to FIG. 2F, the computer 100 (see 262) stores the model detail view (of the partitioned model or stand-alone version of the first portion of the partitioned model) as a restorable view state of the CAD model within the model editing environment or the model-based definition (MBD) environment, whichever is applicable. Thus, in a typical implementation, the computer 100 stores the view state within the model in a manner that facilitates model retrieval for later viewing (e.g., by the user). The computer 100 (at 254) also adds one or more entries, that corresponds to any newly-created partitioned models / views thereof, to a list of stored model views that can be accessed by the user on the computer. As an example, the SOLIDWORKS^{®} software program displays stored model views on its user interface and the user is able to select any one of the stored model views for viewing from the displayed list. In a typical implementation of a SOLIDWORKS^{®}-type environment, the computer 100 (at 256) adds a model detail view or representative name (e.g., "widget cross section," "part model detail view," etc.), preview image (e.g., a thumbnail image), or other user interface element to the list of stored model views within the user interface.

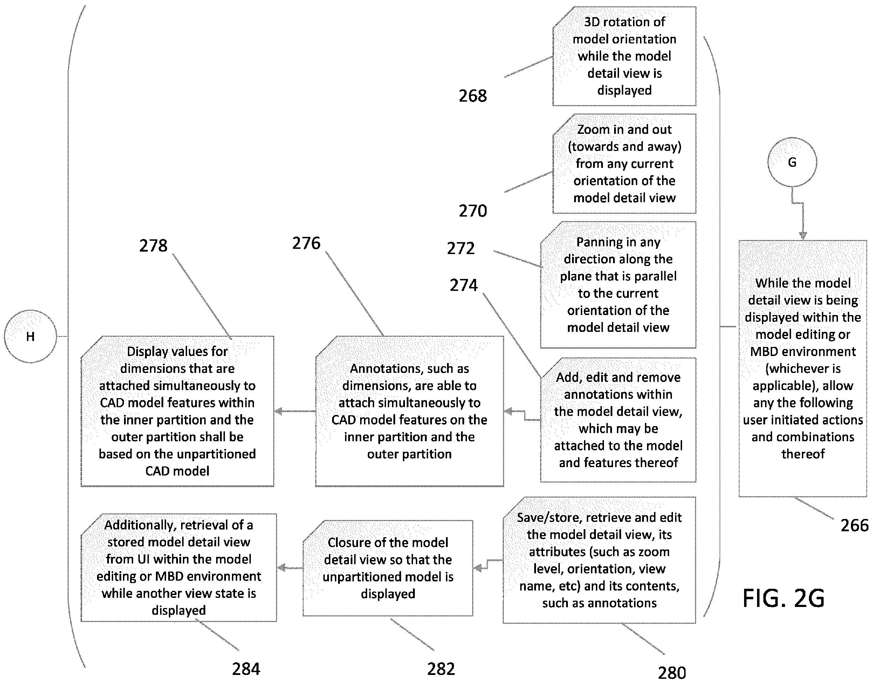

Referring now to FIG. 2G, in a typical implementation, the computer 100 (at 266) enables users to perform any one or more of a number of user initiated actions (or combinations thereof) while the model detail view (i.e., the partitioned model or portion thereof) is being displayed. These include, for example, rotating the model's orientation in any of three dimensions (at 268), zooming in and/or out (towards or away) in any orientation (at 270), and/or panning in any direction (e.g., along a plane that is parallel to the current orientation of the model detail view) (at 272). The computer 100 enables users to add, edit, and/or remove annotations (e.g., within the model detail view) on the model and/or features thereof (see 274).

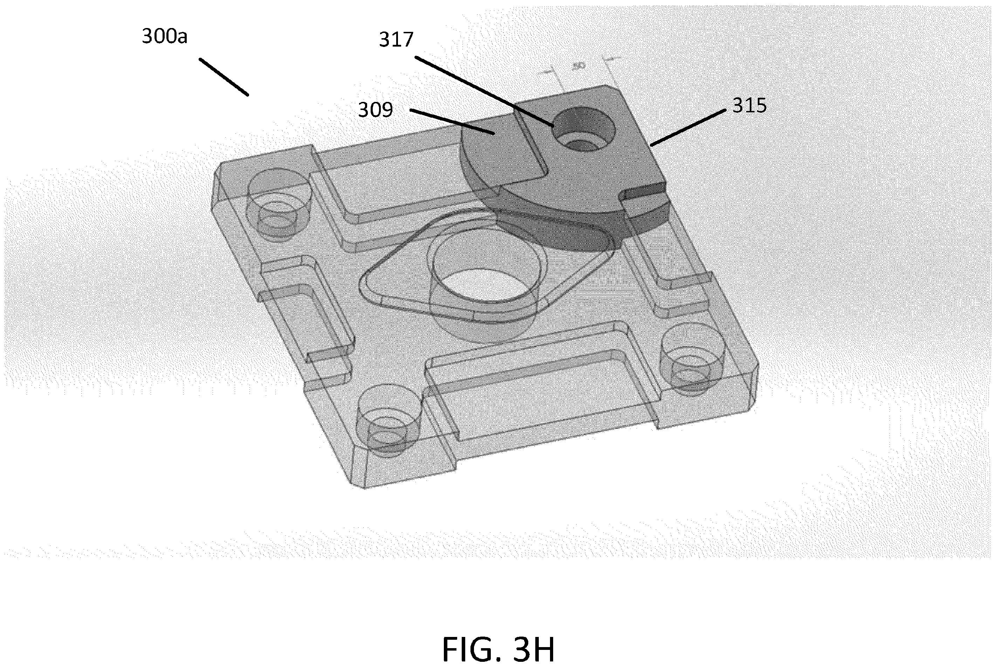

FIG. 3H shows an example of the cropped representation from FIG. 3G but with an annotation thereupon, denoting a dimension of 0.5 between an edge 315 of the first portion 309 of the partitioned model 300a and a center of a hole 317 in the first portion 309 of the partitioned model. The annotation may have been added by a user selecting the edge 315 of the first portion 309 of the partitioned model and the center of the hole in first portion 309 of the partitioned model, while viewing the cropped representation (as shown in FIG. 3G, for example). Once these references have been selected, the computer 100 enables the user to enter a dimension (with units) that corresponds to the distance between the indicated references. If that were the case, then, when the annotation is added to the cropped representation of the computer-generated 3D model, then the computer 100 may automatically update the uncropped version of the computer-generated 3D represented (e.g., shown in FIG. 3A) to include the annotation as well. That way, if the user subsequently changes his or her view from the cropped representation (in FIG. 3H) to an uncropped version of the same representation, the added notation will still be viewable in the uncropped version thereof.

According to the illustrated flowchart, the computer 100 (see 276) enables users to attach annotations, such as dimensions, simultaneously to the inner partition (e.g., the first portion 309 of a partitioned model) and the outer partition (e.g., the second portion 313 of the partitioned model).

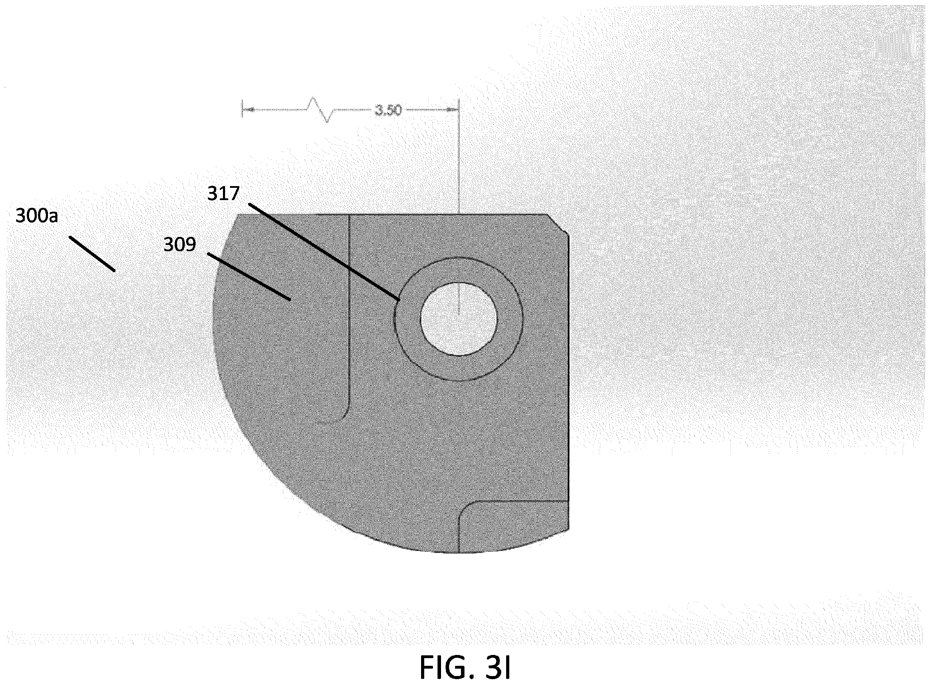

FIG. 3I shows a computer-generated 2D view of the first portion 309 of the partitioned model from FIG. 3G but with an annotation placed thereupon denoting a dimension of 5.5 between the center of hole 317 in the first portion 309 of the partitioned model and a far edge of the object, where the far edge is not part of the first portion 309 of the partitioned model and is not shown in FIG. 3I. The far edge is part of the second portion of the partitioned model, which is not visible in the 2D view of FIG. 3I. The indicated annotation may have been added by a user selecting the far edge of the of the partitioned model and the center of the hole in first portion 309 of the partitioned model while viewing an uncropped representation (as shown in FIG. 3A, for example) or a while viewing a cropped representation that includes both the first and second portions of the partitioned model (as shown in FIG. 3F, for example). Once the user has selected the references, the computer 100 enables the user to enter the dimension (with units) that corresponds to the distance between the indicated references. The view in FIG. 3I can be displayed without the annotated dimension included as well.

Moreover, according to the illustrated flowchart, the computer 100 (see 278) is configured to display values that are attached simultaneously to CAD model features within the inner partition (e.g., the first portion 309 of the partitioned model) and to display dimensions from the unpartitioned CAD model (e.g., the CAD model prior to partitioning) on the outer partition (e.g., the second portion 313 of the partitioned model). Therefore, the computer 100 may display, together, in a partitioned view of the 3D model, for example, the dimension annotated in FIG. 3H and the dimension annotated in FIG. 3I.

The computer 100 (see 280) enables users to save/store, retrieve, and/or edit the model detail view (e.g., the visual depiction of the partitioned CAD model or portion thereof), its attributes (e.g., zoom level, orientation, view name, etc.), and/or its contents, such as annotations (e.g., according to the American Society of Mechanical Engineers (ASME) Y14.41 standard), etc.

The computer 100 (see 282) enables users to close the model detail view (of the partitioned CAD model) and, in response thereto, displays the unpartitioned version of the same CAD model. The computer 100 (see 284) then enables users to retrieve the model detail view again (e.g., of partitioned modeled object), which is stored, by interacting with the user interface within the model editing or model-based definition (MBD) environment while another view state (e.g., the unpartitioned version of the CAD model) is being displayed.

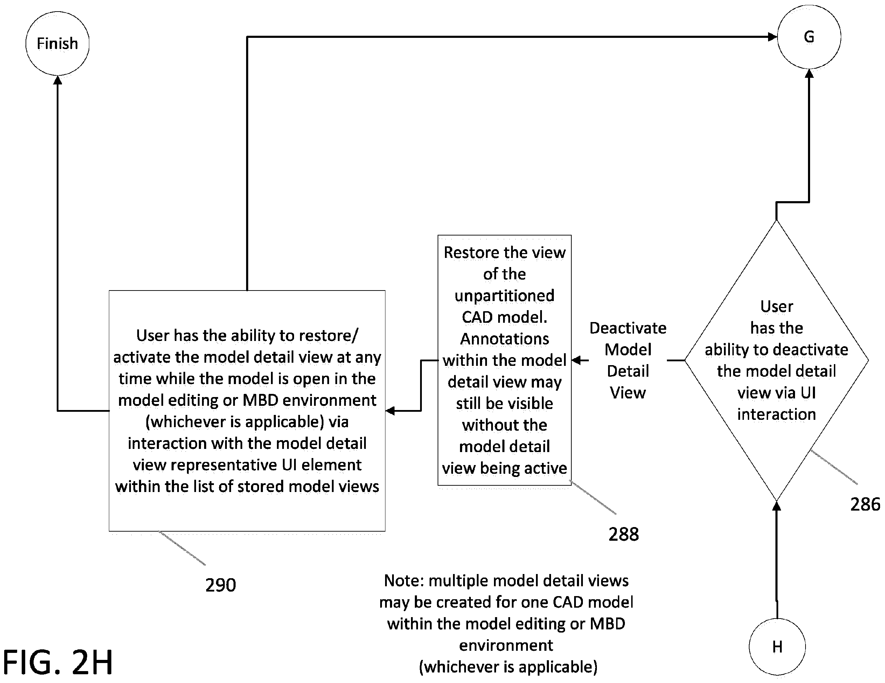

According to the FIG. 2H, if a user (at 286) opts to deactivate a model detail view, then the computer 100 (at 288) may restore a view of the unpartitioned CAD model (i.e., a version of the partitioned CAD model in the model detail view as it appeared prior to partitioning). As noted, annotations within the model detail view may still be visible without the model detail view being active. The computer (at 290) also enables the user to subsequently restore /activate the model detail view at any time while the model is open in the model editing or model-based definition (MBD) environment, whichever is applicable. Typically, the user is able to do this by interacting with (e.g., selecting) the user interface element that represents the model detail view in the list of stored model views. It is worth noting that, in a typical implementation, the computer 100 may be configured to store multiple model detail views for each respective CAD model within the model editing or model-based definition (MBD) environment, whichever is applicable. In this regard, several (or all) of the multiple model detail views may relate to (and be based on) the same cross-section through the modeled object. Alternatively, or additionally, one or more of the multiple model detail views may relate to (and be based on) one or more different cross-sections through the modeled object.

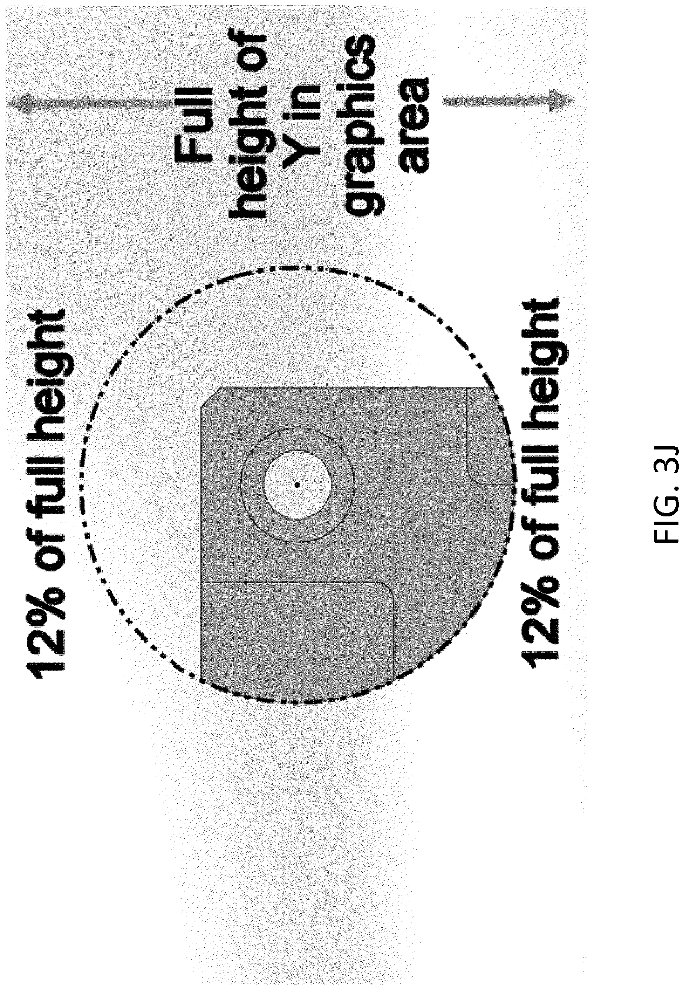

In a typical implementation, the computer 100 enables a user to specify a degree of scaling for a cropped representation of a computer-generated 3D model. FIG. 3J represents an example of scaling in a 2D cropped representation of a computer-generated 3D model. In the illustrated example it can be seen that in the 2D cropped representation of the computer-generated 3D model 12% of the full height of the computer-generated 3D model is shown occupying almost the full available height in the graphics area of the user interface. This gives the viewer the ability to clearly see minute details of the computer-generated 3D model in the area of the cropped representation.

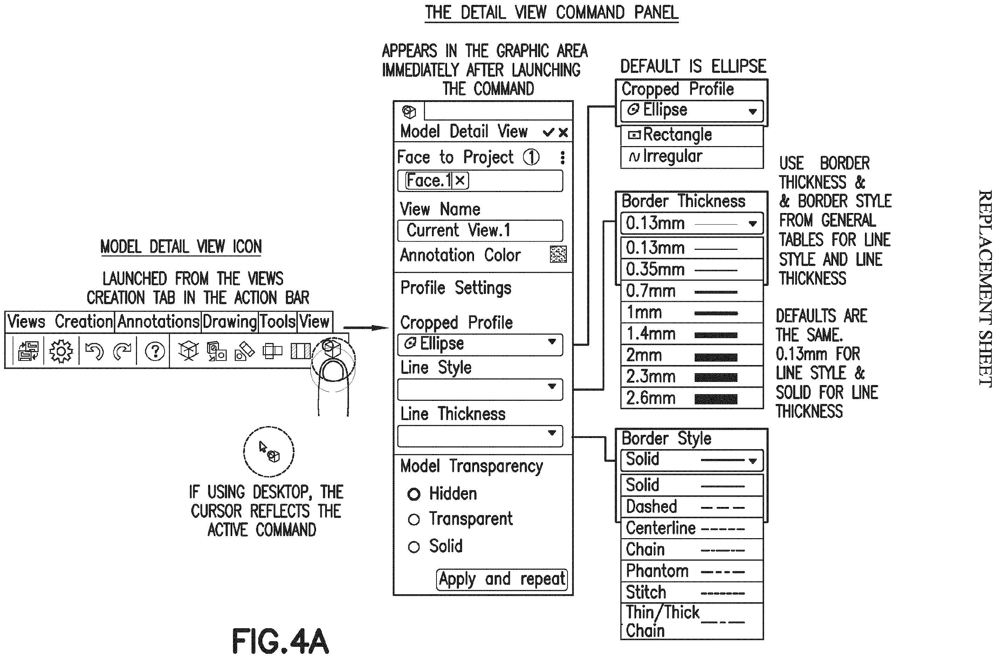

FIG. 4A shows a series of onscreen elements presented to a user to facilitate generating a cropped representation of a CAD 3D model, according to an exemplary implementation.

Starting at the far left, the figure shows an example of a strip of icons that includes one icon (model detail view icon), which is shown closest to the fingertip (and circled), the selection of which (e.g., by touch) launches a user experience that includes access to functionalities disclosed herein related to generating a cropped representation of a CAD 3D model. As indicated in the note provided, in the illustrated implementations, the model detail view icon is embedded in and available for launching in the Views Creation tab in the onscreen Action Bar shown. As also noted, if using a desktop version of the program, for example, a cursor may reflect the active command.

Next, in response to the user selecting the model detail view icon, the computer, according to the illustrated implementation, presents a detail view command panel. As noted, this typically appears in the graphics area immediately after launching the command. The detail view command panel includes a fields entitled "face to project," and "view name." The "face to project" field enables the user to identify to the system a face to project (i.e., a face on which the shape is to be initially placed). The "view name" field enables the user to identify a name for the view being created. An annotation color selector is provided. Additionally, there is a section entitled, "profile settings," which includes a drop down menu for the user to specify a "cropped profile," a "line style," and a line thickness. The selectable options provided in the "cropped shape" menu, according to the illustrated example, include ellipse, rectangle, and irregular. The selectable options provided in the "line style" menu include different border thicknesses for a line that identifies or will identify the border between included and excluded geometries (with a default selection of 0.13 mm in the illustrated example). The range of border thicknesses in the illustrated example range from 0.13 mm to 2.6mm. This range and the specific entries in the range can, of course, vary widely. The selectable options in the "line thickness" menu include different border styles for the line that identifies or will identify the border between included and excluded geometries (with a default selection of solid line in the illustrated example). The range of border styles in the illustrated example include solid, dashed, centerline, chain, phantom, stitch, and then/thick chain. This listing of possible border styles can be modified by addition, subtraction, or replacement.

Finally, there is a "model transparency" section at the bottom of the detail view command panel. The "model transparency" section of the panel enables the user to specify characteristics associated with any excluded geometries in the 3D model. The selectable options provided in the illustrated example include hidden, transparent, and solid.

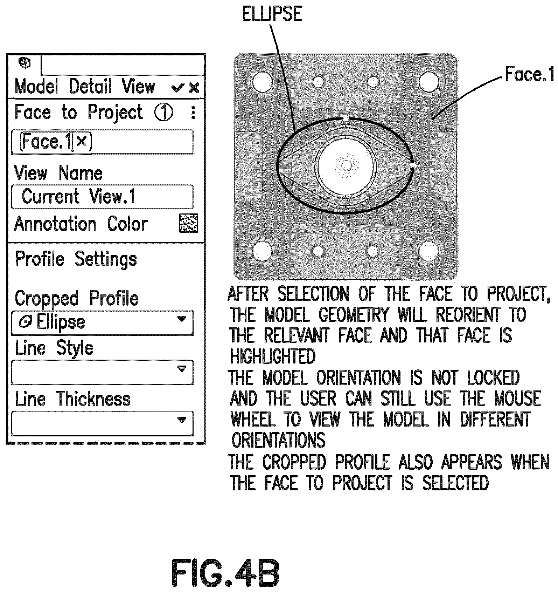

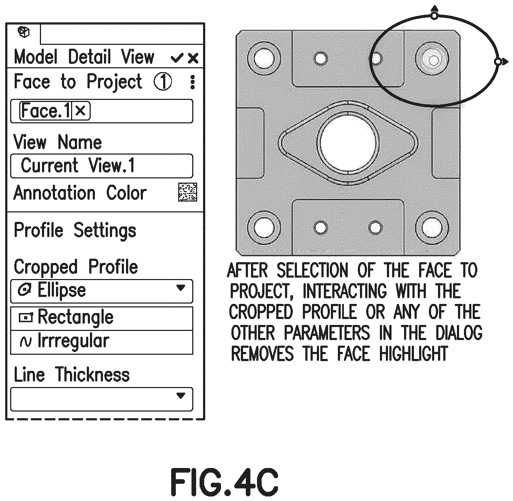

FIGS. 4B and 4C show examples of onscreen elements further presented to the user to facilitate generating a cropped representation of a CAD 3D model, according to the exemplary implementation.

According to FIG. 4B, after the user selects the face to project, the computer 100 orients the relevant face (i.e., the user-selected face, or "face.1" in the illustrated example) for ease of viewing (e.g., facing out towards the viewer) and highlights (or otherwise visually distinguishes) that face. In the illustrated implementation, face.1 on the model is labeled (and is facing outward). It is noted that the model orientation shown is not locked and the user can still use the mouse wheel, for example, to view the model in different orientations. It is further noted that the cropped profile also appears when the "face to project" field is selected. For example, in the illustrated example, the "face to project" field, which contains the face.1 identifier, is selected, and an ellipse, also labeled, appears on the 3D model on face. 1. The ellipse appears because the "ellipse" is selected in the "cropped profile" field.

FIG. 4C notes that after selection of the face to project, user interactions with the cropped profile (or any other parameters in the model detail view dialog box removes the face highlight. In the illustrated example, presumably, the user has selected and moved the ellipse from its original (e.g., centered) position of face.1 to its position shown in FIG. 4C in the upper right corner of the illustrated model. Notably, as a result of this move, face.1 of the model in FIG. 4C is no longer highlighted.

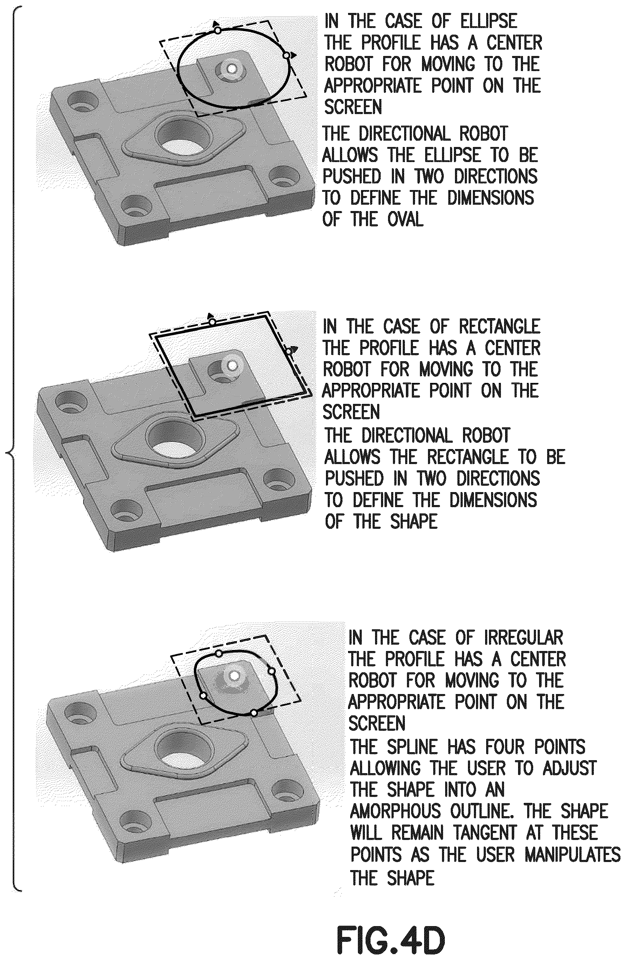

FIG. 4D shows three examples of cropped profiles being placed on a surface of a 3D model. As noted, in the case of an ellipse-shaped cropped profile (in the upper left image), the profile has a center robot for moving to the appropriate point on the screen. Moreover, the directional robot allows the ellipse to be pushed in two directions to define the dimensions of the oval. As further noted, in the case of a rectangular-shaped cropped profile (in the upper right image), the profile also has a center robot for moving to the appropriate point on the screen. Moreover, the directional robot allows the ellipse to be pushed in two directions to define the dimensions of the shape. As even further noted, in the case of an irregular-shaped cropped profile (in the lower image), the profile also has a center robot for moving to the appropriate point on the screen. Moreover, the spline has four points allowing the user to adjust the shape into an amorphous outline. The shape will remain tangent at these points as the user manipulates the shape. Many variations are possible.

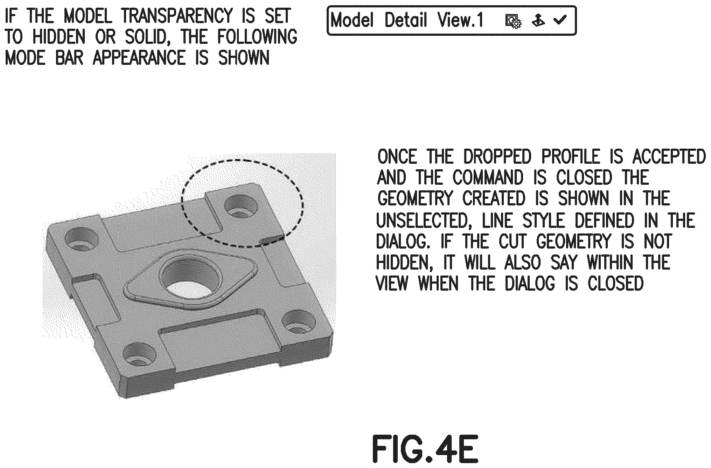

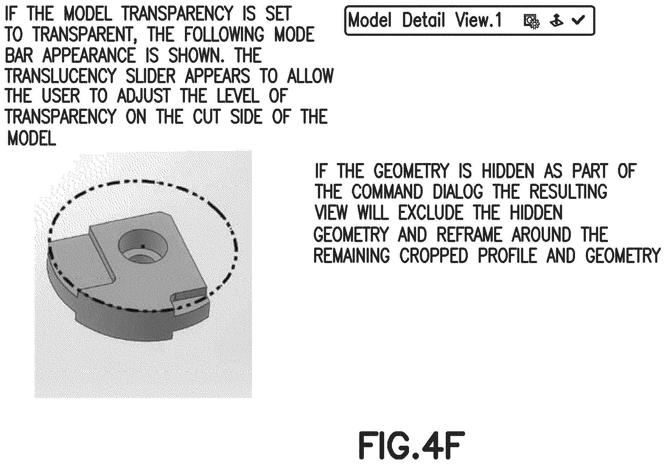

FIG. 4E and FIG. 4F show an example of view appearance and reframing, as well as a mode bar. As noted in the image in FIG. 4E, if the model transparency is set to hidden or solid, the illustrated mode bar is shown. Once the dropped profile is accepted and the command is closed, the geometry created is shown in the unselected line style defined in the dialogue. If the cut geometry is not hidden, it will also say within the view when the dialog is closed. As noted in the image in FIG. 4F, if the model transparency is set to transparent, the mode bar illustrated there is shown. A translucency slider appears to allow the user to adjust a level of transparency on the cut side of the model. As further noted, if the geometry is hidden as part of the command dialog the resulting view will exclude the hidden geometry and reframe around the remaining cropped profile and geometry.

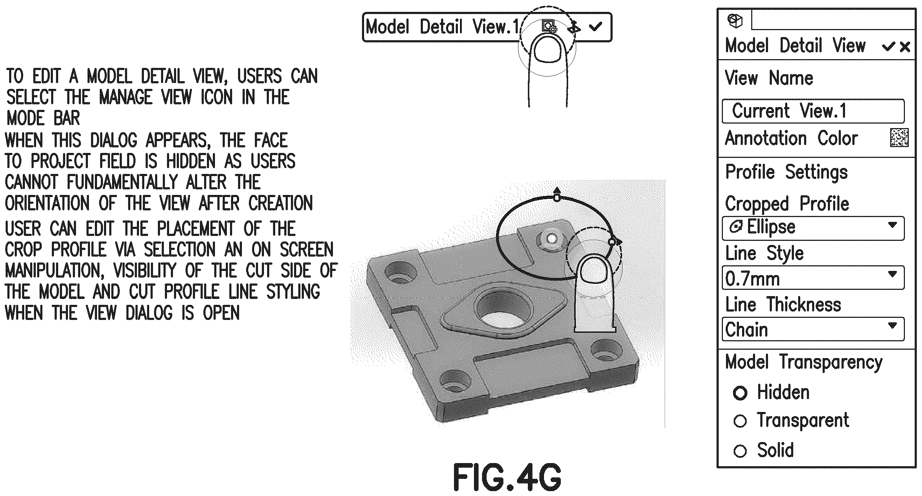

FIG. 4G shows an example of editing a view. As noted, to edit a model detail view, users can select a manage view icon in the mode bar. When this dialog appears, the face to project field is hidden as users cannot fundamentally alter the orientation of the view after creation, in the illustrated implementation. The user can edit the placement of the crop profile via an onscreen manipulation, and visibility of he cut side of the model, and cut profile line styling when the dialog is open.

A number of embodiments of the invention have been described. Nevertheless, it will be understood that various modifications may be made without departing from the spirit and scope of the invention.

A cropped version of a computer-generated 3D CAD model can be displayed in any number of a variety of different ways. For example, the computer 100 may display a computer-generated 3D CAD model with excluded geometry (e.g., the second portion of the partitioned model) shown as either transparent, or as edges only with a special line font that identifies the excluded geometry as not being of standard display quality as the non-excluded geometry (e.g., the first portion of the partitioned model), such as thin dot lines.

There are a variety of ways in which a view of a 3D model may be displayed with a portion (e.g., an excluded portion) removed from view (or otherwise shown as being transparent with an outline only, for example) and a portion (e.g., an included portion) shown. For example, in some implementations, the computer may identify an active view, use a cutting face in the view to identify the portion of the geometry to remove (e.g., exclude) from the display, remove the graphical display of the display elements that make up the identified (excluded) geometry, and keep the graphical display of display elements of all other geometries (e.g., the included geometries) by using a true/false sorting mechanism. This process inherently hides the removed (e.g., excluded) geometry while displaying the remaining (e.g., included) geometry that is behind the removed geometry. Additionally, the computer may apply a graphical display of a cap, for example, as a face where the geometry is intersected by the cutting face.

More specifically, the computer may be configured to provide for multiple (e.g., up to 4) cutting faces in the dialog. These faces may be passed down to the computer's graphic renderer. When the computer draws, the computer 100 still sends the whole model to be rendered as usual, but at composition time, when the computer computes the positions of the pixels to be rendered on screen (fragment shader stage), the computer determines, for each pixel, what side of the cut face it is on. This may be performed using a simple dot product functionality. The computer skips any pixels (called fragments) if they are determined to be on the cut side of the cut face (with discard). The computer essentially skips the rendering of each of those pixels, making the model appear cut on screen. To display the cap, the computer may use a stenciling process whereby the computer identifies the region that was cut and fills it with a color (e.g., blue by default, or color of the component). There is no physical edge or face that can be recognized by the computer along the cut face in that scenario.

Thus, in some implementations, the generation and display of a graphical section view (or cropped representation) is a graphical process, where the computer renders the entire model but applies use a GLSL (OpenGL Shading Language) shader, for example, and discards the fragment that doesn't pass a clip plane test. This function may be used in a fragment shader where the computer discards when it return true.

In various implementations, certain computer components disclosed herein can be implemented by one or more computer-based processors (referred to collectively herein as processor) executing computer-readable instructions stored on non-transitory computer-readable medium to perform corresponding computer-based functionalities. The one or more computer-based processors can be virtually any kind of computer-based processors and can be contained in one housing or distributed across a network and can be at one or more physical locations, and the non-transitory computer-readable medium can be or include any one or more of a variety of different computer-based hardware memory / storage devices either contained in one housing or distributed across a network and can be at one or more different locations.

Certain functionalities are described herein as being accessible or activated by a user selecting an onscreen element (e.g., a button or the like). This should be construed broadly to include any kind of visible, user-selectable element or other user interactive element.

The systems and techniques disclosed herein can be implemented in a number of different ways. In one exemplary implementation, the systems and techniques disclosed herein may be incorporated into the SOLIDWORKS^{®} computer program available from Dassault Systèmes, the applicant of the current application. In various implementations, the systems and techniques can be deployed otherwise.

It should be understood that the example embodiments described herein may be implemented in many different ways. In some instances, the various methods and machines described herein may each be implemented by a physical, virtual, or hybrid general purpose computer, such as a computer system, or a computer network environment, such as those described herein. The computer / system may be transformed into the machines that execute the methods described herein, for example, by loading software instructions into either memory or non-volatile storage for execution by the CPU. One of ordinary skill in the art should understand that the computer / system and its various components may be configured to carry out any embodiments or combination of embodiments of the present invention described herein. Further, the system may implement the various embodiments described herein utilizing any combination of hardware, software, and firmware modules operatively coupled, internally, or externally, to or incorporated into the computer / system.

Various aspects of the subject matter disclosed herein can be implemented in digital electronic circuitry, or in computer-based software, firmware, or hardware, including the structures disclosed in this specification and/or their structural equivalents, and/or in combinations thereof. In some embodiments, the subject matter disclosed herein can be implemented in one or more computer programs, that is, one or more modules of computer program instructions, encoded on computer storage medium for execution by, or to control the operation of, one or more data processing apparatuses (e.g., processors). Alternatively, or additionally, the program instructions can be encoded on an artificially generated propagated signal, for example, a machine-generated electrical, optical, or electromagnetic signal that is generated to encode information for transmission to suitable receiver apparatus for execution by a data processing apparatus. A computer storage medium can be, or can be included within, a computer-readable storage device, a computer-readable storage substrate, a random or serial access memory array or device, or a combination thereof. While a computer storage medium should not be considered to be solely a propagated signal, a computer storage medium may be a source or destination of computer program instructions encoded in an artificially generated propagated signal. The computer storage medium can also be, or be included in, one or more separate physical components or media, for example, multiple CDs, computer disks, and/or other storage devices.

Certain operations described in this specification (e.g., aspects of those represented in the flowcharts and/or otherwise disclosed herein) can be implemented as operations performed by a data processing apparatus (e.g., a processor / specially programmed processor / computer) on data stored on one or more computer-readable storage devices or received from other sources, such as a computer system and/or network environment. The term "processor" (or the like) encompasses all kinds of apparatus, devices, and machines for processing data, including by way of example a programmable processor, a computer, a system on a chip, or multiple ones, or combinations, of the foregoing. The apparatus can include special purpose logic circuitry, e.g., an FPGA (field programmable gate array) or an ASIC (application specific integrated circuit). The apparatus can also include, in addition to hardware, code that creates an execution environment for the computer program in question, for example, code that constitutes processor firmware, a protocol stack, a database management system, an operating system, a cross-platform runtime environment, a virtual machine, or a combination of one or more of them. The apparatus and execution environment can realize various different computing model infrastructures, such as web services, distributed computing and grid computing infrastructures.

While this specification contains many specific implementation details, these should not be construed as limitations on the scope of any inventions or of what may be claimed, but rather as descriptions of features specific to particular embodiments of particular inventions. Certain features that are described in this specification in the context of separate embodiments can also be implemented in combination in a single embodiment. Conversely, various features that are described in the context of a single embodiment can also be implemented in multiple embodiments separately or in any suitable subcombination. Moreover, although features may be described above as acting in certain combinations and even initially claimed as such, one or more features from a claimed combination can in some cases be excised from the combination, and the claimed combination may be directed to a subcombination or variation of a subcombination.

Similarly, while operations may be described herein as occurring in a particular order or manner, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Other implementations are within the scope of the claims.

## Claims

1. A computer-based method that comprises creating a cropped representation of a computer-generated, three-dimensional (3D) computer aided design (CAD) model for use in manufacturing a real-world object based on the computer-generated 3D CAD model, the method comprising:
displaying the computer-generated 3D CAD model on a computer display;
receiving an indication that an element from the displayed computer-generated 3D model has been selected as target geometry for placement of a boundary shape;
creating the boundary shape on the selected target geometry in response to input defining the boundary shape;
extending a perimeter of the boundary shape in a normal direction through the computer-generated 3D CAD model to establish a boundary that passes through the computer-generated 3D CAD model;
partitioning the computer-generated 3D CAD model at the boundary to demarcate a first portion of the computer-generated 3D CAD model inside the boundary from a second portion of the computer-generated 3D CAD model outside the boundary; and
generating a visual depiction of the cropped representation of the computer-generated 3D CAD model based on the partitioned computer-generated 3D CAD model by visually displaying the first portion of the computer-generated 3D CAD model inside the boundary and by hiding or displaying as transparent with edges only the second portion of the computer-generated 3D CAD model outside the boundary.

2. The computer-based method of claim 1, further comprising displaying the boundary as a solid surface in the visual depiction of the cropped representation of the computer-generated 3D CAD model.

3. The computer-based method of claim **1,** further comprising:
determining, before creating the boundary shape, whether the element selected as target geometry is a valid selection for placement of the boundary shape.

4. The computer-based method of claim 3, wherein determining whether the element selected as target geometry is a valid selection for placement of the boundary shape comprises:
confirming that the selected element is a flat face or reference geometric plane on the computer-generated 3D model.

5. The computer-based method of claim 1, wherein creating the boundary shape on the selected target geometry comprises:
prompting selection of a type of boundary shape for placement on the selected target geometry;
receiving an indication that a boundary shape type has been selected in response to the prompting;
activating a draw tool that corresponds to the selected boundary shape type to enable creating the boundary shape in a form that corresponds to the selected boundary shape type; and
receiving input from the draw tool to generate and locate the boundary shape on the selected target geometry.

6. The computer-based method of claim 1, further comprising:
storing the boundary shape as supplemental geometry or as a sketch entity in logical association with the cropped representation of the computer-generated 3D CAD model being created and for which the boundary shape was created.

7. The computer-based method of claim 1, wherein generating the visual depiction of the cropped representation of the computer-generated 3D CAD model based on the partitioned computer-generated 3D CAD model comprises:
providing the computer-generated 3D CAD model, in its entirety, to a graphics renderer of the computer for generating the visual depiction;
determining, for each pixel of the computer-generated 3D CAD model provided to the graphics renderer, whether that pixel is in the first portion of the computer-generated 3D CAD model or in the second portion of the computer-generated 3D CAD model; and
deciding whether to render that pixel based on whether that pixel is determined to be in the first portion of the computer-generated 3D CAD model or in the second portion of the computer-generated 3D CAD model.

8. The computer-based method of claim 1, further comprising:
storing the cropped representation of the computer-generated 3D CAD model as a restorable view state of the computer-generated 3D CAD model.

9. The computer-based method of claim 1, further comprising:
using the computer-generated 3D CAD model and the cropped representation of the computer-generated 3D CAD model to manufacture a real world object that corresponds to the computer-generated 3D CAD model and the cropped representation of the computer-generated 3D CAD model.

10. The computer-based method of claim 9, wherein using the computer-generated 3D CAD model and the cropped representation of the computer-generated 3D CAD model to manufacture the real world object comprises:
transferring data associated with the computer-generated 3D CAD model and the cropped representation of the computer-generated 3D CAD model into a computer numerical control (CNC) machine, via an interface on the computer, to direct the CNC machine to produce the real-world object.

11. A system comprising:
a computer comprising:
a computer processor;
a computer display screen; and
computer-based memory operatively coupled to the computer processor, wherein the computer-based memory stores computer-readable instructions that, when executed by the computer processor, cause the computer-based system to perform the method according to any one of claims 1 to 10.

12. A non-transitory computer readable medium having stored thereon computer-readable instructions that, when executed by a computer-based processor, cause the computer-based processor to perform the method of any one of claims 1 to 10.

13. A computer program comprising instructions which, when executed by a computer system, cause the computer system to perform the method according to any one of claims 1 to 10.
